# EUROPÄISCHE PATENTSCHRIFT

(11) **EP 1 504 471 B1**
(45) Veröffentlichungstag und Bekanntmachung des Hinweises auf die Patenterteilung: **21.04.2010**
(21) Anmeldenummer: 03737900.5
(22) Anmeldetag: 15.05.2003
(51) Int. Cl.: H01L 27/115, H01L 21/8247, H01L 21/8246

(54) **SCHICHTANORDNUNG SOWIE SPEICHERANORDNUNG**
LAYER ARRANGEMENT AND MEMORY ARRANGEMENT
ENSEMBLE COUCHES ET ENSEMBLE MEMOIRE

(30) Priorität: 16.05.2002 DE 10221884
(43) Veröffentlichungstag der Anmeldung: 09.02.2005
(73) Patentinhaber: Infineon Technologies AG, 81669 München (DE)
(72) Erfinder: HAGEMEYER, Peter, 01097 Dresden (DE); LANGHEINRICH, Wolfram, 01324 Dresden (DE)
(74) Vertreter: Viering, Hans-Martin
(86) Internationale Anmeldenummer: PCT/DE2003/001581
(87) Internationale Veröffentlichungsnummer: WO 2003/098694

(56) Entgegenhaltungen:
- EP-A- 0 305 741
- US-A- 5 933 730
- US-A- 6 037 222

## Beschreibung

Die Erfindung betrifft ein Verfahren zum Herstellen einer Schicht-Anordnung, eine Schicht-Anordnung und eine Speicher-Anordnung.

Angesichts der schnellen Fortentwicklung der Computertechnologie besteht Bedarf an einem Speichermedium, welches die Speicherung einer immer größeren Speichermenge auf immer kleineren Anordnungen ermöglicht. Im Bereich der nichtflüchtigen Speicher, welche, wenn sie einmal mit der zu speichernden Information programmiert sind, diese dauerhaft ohne Informationsverlust aufrechterhalten, werden üblicherweise Datenmengen von einem Bit oder mehr in jedem Transistor einer großen Anordnung von Transistoren gespeichert. Einen Überblick über nichtflüchtige Speicher gibt beispielsweise [1].

Die herkömmliche Silizium-Mikroelektronik wird bei weiter voranschreitender Verkleinerung an ihre Grenzen stoßen. Insbesondere die Entwicklung zunehmend kleinerer und dichter angeordneter Transistoren von mittlerweile mehreren hundert Millionen Transistoren pro Chip wird in den nächsten zehn Jahren prinzipiellen physikalischen Problemen ausgesetzt sein. Wenn Strukturabmessungen von 80nm unterschritten werden, werden die Bauelemente durch Quanteneffekte störend beeinflusst und unterhalb von Dimensionen von etwa 30nm dominiert. Auch führt die zunehmende Integrationsdichte der Bauelemente auf einem Chip zu einem dramatischen Anstieg der Abwärme. Daher ist die Erhöhung der Speicherdichte von Transistor-Anordnungen mittels forschreitender Verkleinerung der Struktur-Dimensionen ein Konzept, das an die zugrundeliegenden Herstellungsverfahren hohe technologische Anforderungen stellt.

Bei einer sogenannten "embedded" Technologie sind Transistoren mit unterschiedlichen Anforderungen in einem einzigen integrierten Schaltkreis, d.h. in einem Chip, integriert. Beispielsweise kann es erforderlich sein, Transistoren unterschiedlicher Ausgestaltung in einem Speicher-Bereich des Chips (beispielsweise in einer Flash-Speicher-Anordnung oder einem EEPROM) und in einem Logik-Bereich des integrierten Schaltkreises zu integrieren. In einem solchen Szenario sind an die strukturellen und physikalischen Parameter der integrierten Transistoren unterschiedliche Anforderungen zu stellen.

Um einen Transistor in einem Logik-Bereich auszubilden, welcher Logik-Bereich eine ausreichende Schnelligkeit aufweisen soll, soll ein solcher Logik-Transistor von dessen Umgebung durch eine möglichst dünne Seitenwandoxid-Schicht getrennt sein. Eine dünne Seitenwandoxid-Schicht ist bei einem Logik-Transistor erforderlich, um einen niederohmigen Anschlusswiderstand zu gewährleisten: Eine als Logik-Transistor dienende Schicht-Anordnung auf einem Substrat ist mit der Umgebung koppelbar, indem in den beidseitigen Grenzbereichen zwischen der lateral begrenzten Schicht-Anordnung und dem Substrat Dotieratome injiziert werden ("lightly doped drain"). Ist die Seitenwandoxid-Schicht bei einem Logik-Transistor zu dick ausgebildet, so ist der Überlappungsbereich des dotierten Bereichs in dem Silizium-Substrat mit dem Gateoxid-Bereich des Transistors gering, so dass der Logik-Transistor hochohmig ist. Mit anderen Worten ist der Logik-Transistor um so hochohmiger, je weiter außerhalb der beidseitigen Endabschnitte des Logik-Transistors die lightly doped Drain-Bereiche ausgebildet sind. Um eine ausreichende Schnelligkeit des Logik-Transistors zu gewährleisten, sollte die Seitenwandoxid-Schicht des Logik-Transistors daher hinreichend dünn sein (z.B. bei 130nm Technologiegeneration ca. 5nm bis 7nm). Andererseits ist das Vorhandensein einer Seitenwandoxid-Schicht in einem Logik-Bereich wichtig, um eine wohldefinierte Oberfläche an der Seitenwand der Gate-Elektrode aus Poly-Silizium (polykristallines Silizium) zu bilden, um Oberflächenladungen, wie sie beispielsweise während des Herstellungsverfahrens des Logik-Transistors auftreten, abzusättigen und um Plasmaätz-Schäden auszuheilen, wie sie beispielsweise bei dem bei der Herstellung von Transistoren häufig angewandten CVD-Verfahren ("chemical vapour deposition") entstehen können.

Andererseits wird bei der Seitenwandoxid-Schicht eines Speicher-Transistors in einem Flash-Speicher oder einem EEPROM-Speicher eine ausreichend dicke Seitenwandoxid-Schicht angestrebt. Eine ausreichend dicke Seitenwandoxid-Schicht bewirkt in einer Ladungsspeicher-Schicht ein sicheres Halten der in dem Speicher-Transistor gespeicherten Information, die in der in der Ladungsspeicher-Schicht enthaltenen Menge elektrischer Ladung kodiert ist. Dies führt zu einer ausreichend hohen Haltezeit der gespeicherten Information, was für die Funktionalität eines Speicher-Transistors essentiell ist. Ferner führt eine dicke Seitenwandoxid-Schicht in einem Speicher-Transistor dazu, dass Ionenschäden an der Tunneloxid-Kante, welche die Funktionalität eines Speicher-Transistors negativ beeinflussen, vermieden sind bzw. dass unerwünschte Aufladungen des Floating-Gates durch nachfolgende Implantationen von Ionen zum Ausbilden dotierter Bereiche in Oberflächen-Bereichen eines Substrats vermieden sind. Ferner werden mittels einer ausreichend dicken Seitenwandoxid-Schicht von einem während des Herstellens des Speicher-Transistors häufig ausgebildeten Abstandshalter aus Siliziumnitrid verursachte Grenzladungen vom Floating-Gate bzw. von der Gateoxid-Schicht ferngehalten und so die einwandfreie Funktionalität des Speicher-Transistors sichergestellt. Die Dicke des Seitenwandoxids in einem Speicher-Transistor sollte mindestens 10nm aufweisen.

Die gegensätzlichen Anforderungen an die Dicken der Seitenwandoxid-Schichten in einem Logik-Transistor und in einem Speicher-Transistor auf einem Chip, der sowohl einen Logik-Bereich mit einer schnellen integrierten Logik zum Ansteuern des Speicher-Bereichs und einen Speicher-Bereich mit einer Vielzahl von Speicher-Transistoren aufweist, sind im Stand der Technik häufig lediglich dadurch berücksichtigt, dass eine einheitliche Dicke der Seitenwandoxid-Schichten der Logik-Transistoren und der Speicher-Transistoren gewählt wird. Diese einheitliche Dicke ist ausreichend klein gewählt, um in dem Logik-Bereich einen Logik-Transistor mit einer einigermaßen akzeptablen Seitenwand-Dicke zu erhalten, und die einheitliche Dicke ist ausreichend groß gewählt, um in dem Speicher-Bereich einen Speicher-Transistor mit einer einigermaßen akzeptablen Seitenwand-Dicke zu erhalten. Diese Kompromisslösung wirkt sich aus den oben genannten Gründen allerdings nachteilig auf die Funktionalität beider Typen von Transistoren aus.

Eine solche Kompromisslösung ist bei Technologien, die Transistoren mit einer Länge des Gate-Bereichs von 130nm und weniger zum Gegenstand haben, zunehmend ungeeignet, wenn eine einwandfreie Funktionalität der derartig hergestellten integrierten Schaltkreise sichergestellt sein soll. Für einen Transistor mit einer Länge des Gate-Bereichs von 130nm und weniger ist für einen einwandfrei funktionsfähigen und ausreichend schnellen Logik-Transistor eine Seitenwandoxid-Dicke von deutlich weniger als 10nm erforderlich, was für einen Speicher-Transistor in einem Flash-Speicher bzw. einem EEPROM deutlich zu wenig ist.

Aus dem Stand der Technik ist ein Verfahren bekannt, das die Herstellung eines integrierten Schaltkreises mit einem auf einem gemeinsamen Chip integrierten Logik-Bereich mit einem Logik-Transistor und mit einem Speicher-Bereich mit einem Speicher-Transistor ermöglicht, und bei dem die Seitenwandoxid-Dicke des Logik-Transistors und des Speicher-Transistors unterschiedlich ausbildbar sind.

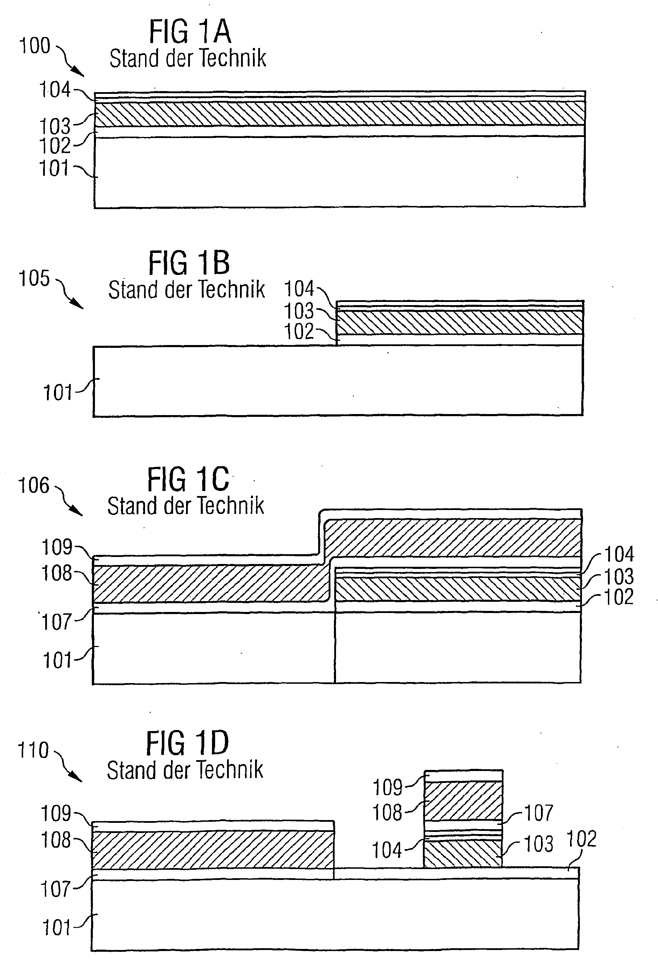

Ein solches Verfahren, welches das Ausbilden von Logik-Transistoren mit einem Seitenwandoxid, das dünner als das Seitenwandoxid von auf demselben integrierten Schaltkreis ausgebildeten Speicher-Transistoren ist, wird im Folgenden bezugnehmend auf **Fig.1A** bis **Fig.1I** beschrieben.

In den genannten Figuren stellt jeweils ein linker Bereich der gezeigten Schichtstrukturen einen Logik-Bereich eines integrierten Schaltkreises dar (genauer gesagt einen Logik-Transistor des Logik-Bereichs), und der rechts gezeigte Bereich stellt einen Speicher-Bereich (genauer gesagt einen Speicher-Transistor des Speicher-Bereichs) des integrierten Schaltkreises dar. Dies ist in **Fig.1A** bis **Fig.1I** optisch **dadurch gekennzeichnet, dass** eine gestrichelte senkrechte Linie eingezeichnet ist, die den links von der gestrichelten Linie ausgebildeten Logik-Bereich von dem rechts von der gestrichelten Linie gezeigten Speicher-Bereich trennt.

Um auf die in **Fig.1A** gezeigte Schichtstruktur 100 zu gelangen, wird auf einem Silizium-Substrat 101 eine erste Siliziumdioxid-Schicht 102, eine erste Poly-Silizium-Schicht 103 und eine ONO-Schichtenfolge 104 abgeschieden. Eine ONO-Schichtenfolge ist eine dreilagige Schichtenfolge aus jeweils einer Schicht aus Siliziumdioxid, Siliziumnitrid und Siliziumdioxid. Die erste der Siliziumdioxid-Schichten der ONO-Schichtenfolge 104 wird auf der ersten Poly-Silizium-Schicht 103 abgeschieden, auf der ersten Siliziumdioxid-Schicht der ONO-Schichtenfolge 104 wird die Siliziumnitrid-Schicht der ONO-Schichtenfolge 104 abgeschieden, und auf der Siliziumnitrid-Schicht der ONO-Schichtenfolge 104 wird die zweite Siliziumdioxid-Schicht der ONO-Schichtenfolge 104 abgeschieden.

Die in **Fig.1B** gezeigte Schichtstruktur 105 wird erhalten, indem unter Verwendung eines Lithographie- und eines Ätz-Verfahrens die erste Siliziumdioxid-Schicht 102, die erste Poly-Silizium-Schicht 103 und die ONO-Schichtenfolge 104 von dem gesamten Logik-Bereich entfernt wird.

Um von der in **Fig.1B** gezeigten Schichtstruktur 105 auf die in **Fig.1C** gezeigte Schichtstruktur 106 zu gelangen, wird auf der gesamten Oberfläche der Schichtstruktur 105 eine zweite Siliziumdioxid-Schicht 107, eine zweite Poly-Silizium-Schicht 108 und eine geeignete Hartmaske 109 abgeschieden.

Die in **Fig.1D** gezeigte Schichtstruktur 110 wird erhalten, indem im Speicher-Bereich (d.h. in dem Bereich rechts von der gestrichelten Linie in **Fig.1C, Fig.1D****)** eine Strukturierung der Schichtstruktur durchgeführt wird, wohingegen der Logik-Bereich (Bereich links von der gestrichelten Linie in **Fig.1C, Fig.1D****)** abgedeckt ist. Da die in dem Speicher-Bereich ausgebildeten Strukturen innerhalb eines geringen strukturellen Toleranzbereichs liegen müssen, ist dieser Strukturierungs-Schritt kritisch. Das bedeutet, dass sich bereits geringe Ungenauigkeiten bei diesem Verfahrensschritt stark auf die Funktionalität des auf diese Weise hergestellten integrierten Schaltkreises auswirken. Daher erfordert dieser Verfahrensschritt eine genaue Justage der Prozessbedingungen, was diesen Verfahrensschritt aufwändig und teuer macht. Wie in **Fig.1D** gezeigt, werden in dem Speicher-Bereich lediglich die obersten fünf Schichten strukturiert, wohingegen die erste Siliziumdioxid-Schicht 102 auch in dem Speicher-Bereich erhalten bleibt. Dies ist durch Verwendung eines geeigneten Ätz-Verfahrens realisierbar, das derart eingerichtet ist, dass das Ätz-Prozess vor der ersten Siliziumdioxid-Schicht 102 stoppt.

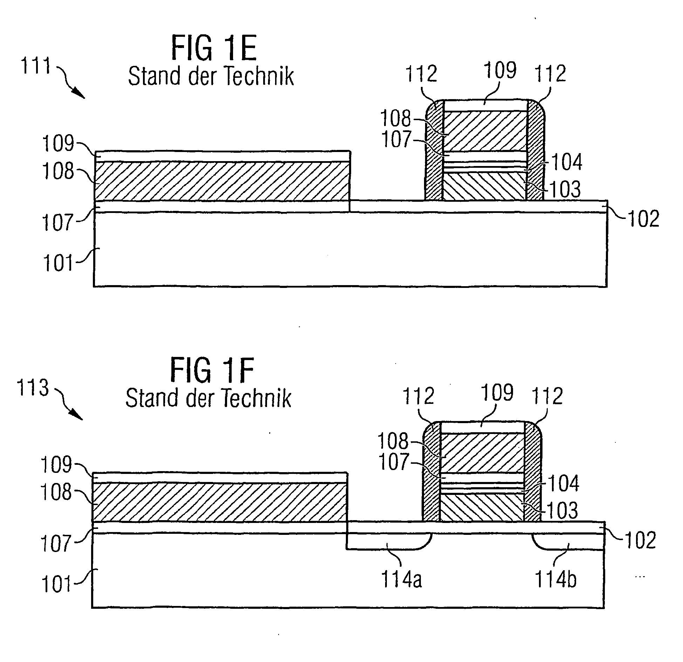

Um auf die in **Fig.1E** gezeigte Schichtstruktur 111 zu gelangen, wird die in dem Speicher-Bereich nach der Strukturierung zurückbleibende lateral begrenzte Schichtenfolge mit einer ersten Seitenwandoxid-Schicht 112 bedeckt. Dieses Seitenwandoxid wächst zunächst auch auf von der lateral begrenzten Schichtenfolge verschiedenen Oberflächenbereichen auf, auch über den Schichten 102 und 109, und kann zurückgeätzt werden, wodurch die Schichtenfolge 111 aus Fig.1E erhalten wird. Dies führt in dem gesamten Logik-Bereich während dieses Verfahrensschrittes lediglich zu einer geringfügigen Erhöhung der Hartmaskenschicht 109 (nicht gezeigt). Mit anderen Worten wird die Seitenwand der lateral begrenzten Schichtenfolge im Speicher-Bereich mit der ersten Seitenwandoxid-Schicht 112 bedeckt, wohingegen der Logik-Bereich nahezu unverändert bleibt.

Die in **Fig.1F** gezeigte Schichtstruktur 113 wird erhalten, indem der Logik-Bereich weiterhin abgedeckt bleibt, wohingegen in die von der lateral begrenzten Schichtenfolge freien Oberflächen-Bereiche des Silizium-Substrats 101 unter Verwendung eines Ionenimplantations-Verfahrens Dotieratome eingebracht werden, wodurch die LDD-Bereiche 114a, 114b ("lightly doped drain") ausgebildet werden.

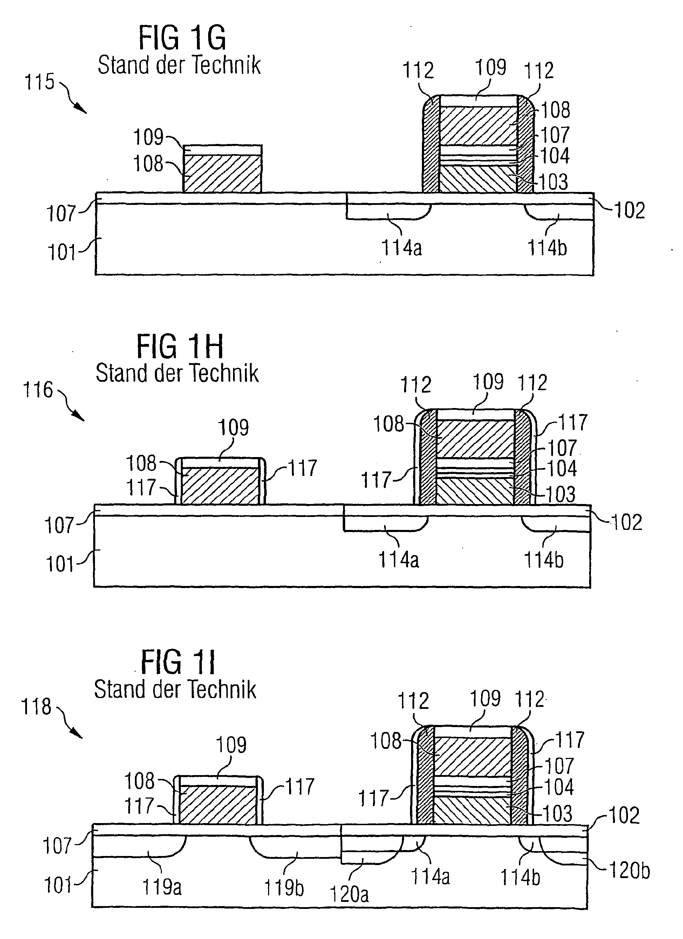

Um auf die in **Fig.1G** gezeigte Schichtstruktur 115 zu gelangen, wird der nun Speicher-Bereich vollständig abgedeckt und der Logik-Bereich unter Verwendung eines Lithographie- und eines Ätz-Verfahrens strukturiert. Um den Logik-Bereich in eine seitlich begrenzte Schichtenfolge zu strukturieren, ist eine weitere kritische Strukturierung erforderlich. Dies bedeutet, dass sich bereits geringe Schwankungen in der Prozessführung empfindlich in nachteilhafter Weise auf die Funktionalität der auf diese Weise gebildeten Logik-Bereiche auswirken. Wie die oben beschriebene erste kritische Strukturierung erfordert auch dieser Verfahrensschritt eine aufwändige und teure Prozessführung, die einen hohen Grad an Genauigkeit erfordert. Wie in **Fig.1G** gezeigt, werden nur die beiden obersten Schichten, nämlich die zweite Poly-Silizium-Schicht 108 und die Hartmaske 109 strukturiert, wohingegen die zweite Siliziumdioxid-Schicht 107 infolge Verwendens eines geeigneten Ätz-Verfahrens von der Oberfläche der in dem Logik-Bereich angeordneten Schichtstruktur nicht entfernt wird. Dadurch verbleibt auf dem Logik-Bereich die in **Fig.1G** gezeigte, lateral begrenzte Schichtenfolge aus der zweiten Poly-Silizium-Schicht 108 und der Hartmaske 109.

Die in **Fig.1H** gezeigte Schichtstruktur 116 wird erhalten, indem sowohl im Logik-Bereich als auch im Speicher-Bereich des Flash-Speichers bzw. des EEPROMs auf die lateral begrenzten Schichtenfolgen jeweils eine zweite Seitenwandoxid-Schicht 117 aufgebracht wird. Dies wird durch thermisches Oxidieren der Seitenwände realisiert. Die zweite Seitenwandoxid-Schicht 117 weist eine geringere Dicke auf als die erste Seitenwandoxid-Schicht 112. Wie in **Fig.1H** gezeigt, weist die lateral begrenzte Schichtenfolge in dem Logik-Bereich daher ein Seitenwandoxid auf, das der Dicke der zweiten Seitenwandoxid-Schicht 117 entspricht, wohingegen die lateral begrenzte Schichtenfolge in dem Speicher-Bereich eine Seitenwandoxid-Schicht aufweist, deren Dicke sich aus jener der ersten Seitenwandoxid-Schicht 112 und der zweiten Seitenwandoxid-Schicht 117 zusammensetzt.

Um die in **Fig.1I** gezeigte Schichtstruktur 118 zu erhalten, werden sowohl in dem Logik-Bereich als auch in dem Speicher-Bereich Implantationen durchgeführt, wodurch in dem Logik-Bereich der erste dotierte Bereich 119a und der zweite dotierte Bereich 119b erhalten wird. In dem Speicher-Bereich wird dadurch der erste HDD-Bereich 120a und der zweite HDD-Bereich 120b an den beidseitigen Endabschnitten der lateral begrenzten Schichtenfolgen erzeugt. HDD bedeutet "highly doped drain", wodurch zum Ausdruck gebracht ist, dass die Konzentration von Dotieratomen in den HDD-Bereichen 120a, 120b größer ist als in den LDD-Bereichen 114a, 114b. Die in dem Logik-Bereich ausgebildete lateral begrenzte Schichtenfolge stellt einen Transistor mit einem Seitenwandoxid der Dicke der zweiten Seitenwandoxid-Schicht 117 dar. Der erste dotierte Bereich 119a repräsentiert den ersten Source-/Drain-Bereich, wohingegen der zweite dotierte Bereich 119b den zweiten Source-/Drain-Bereich darstellt. Die zweite Siliziumdioxid-Schicht 107 in dem Logik-Bereich stellt die Gateoxid-Schicht dar und die zweite Poly-Silizium-Schicht 108 stellt in dem Logik-Bereich die Gate-Elektrode dar. Die zweite Seitenwandoxid-Schicht 117 dient zum seitlichen Abschirmen des Transistors, und die Hartmaske 109 dient ebenfalls als Schutzschicht.

Die in dem Speicher-Bereich ausgebildete lateral begrenzte Schichtenfolge kann als Speicher-Transistor verwendet werden. Der erste LDD-Bereich 114a und der erste HDD-Bereich 120a bilden den ersten Source-/Drain-Bereich, der zweite LDD-Bereich 114b und der zweite HDD-Bereich 120b bilden den zweiten Source-/Drain-Bereich. Die erste Siliziumdioxid-Schicht 102 stellt den Gateoxid-Bereich dar. Die erste Poly-Silizium-Schicht 103 kann die Funktionalität eines Floating-Gates wahrnehmen, in die beispielsweise mittels Fowler-Nordheim-Tunnels oder mittels heißer Elektronen Ladungsträger dauerhaft injizierbar sind. Die ONO-Schichtenfolge 104 und die zweite Siliziumdioxid-Schicht 107 bewerkstelligen eine elektrische Entkopplung des Floating-Gates von der zweiten Poly-Silizium-Schicht 108, welche die Funktionalität einer Gate-Elektrode wahrnehmen kann. Die Hartmaske 109 stellt eine Schutzschicht dar, und eine ausreichend dicke Seitenwandoxid-Schicht des Speicher-Transistors wird durch die erste Seitenwandoxid-Schicht 112 und die zweite Seitenwandoxid-Schicht 117 realisiert.

Jedoch weist das beschriebene Verfahren zum Ausbilden von Logik-Transistoren und Speicher-Transistoren mit unterschiedlichen Seitenwandoxid-Dicken eine Reihe von Nachteilen auf. Wie oben beschrieben, sind während des Verfahrens zwei kritische Lithographieschritte erforderlich, bei denen geringe Abweichungen zu weitreichenden negativen Folgen für die Funktionalität der Anordnung führen. Die Durchführung dieser beiden kritischen Lithographieschritte macht das Herstellen der Schichtstruktur 118 aufwändig und teuer.

Ein weiterer Nachteil des beschriebenen Herstellungsverfahrens basiert darauf, dass die GateStrukturierung der Logik-Transistoren einerseits und der Speicher-Transistoren andererseits in zwei voneinander getrennten Verfahrensschritten durchgeführt werden. Die Strukturierung der Speicher-Transistoren erfolgt bei dem Verfahrensschritt, bei dem ausgehend von der in **Fig.1C** gezeigten Schichtstruktur 106 die in **Fig.1D** gezeigte Schichtstruktur 110 ausgebildet wird. Dagegen erfolgt die Strukturierung der Logik-Transistoren in dem Verfahrensschritt, bei dem ausgehend von der in **Fig.1F** gezeigten Schichtstruktur 113 die in **Fig.1G** gezeigte Schichtstruktur 115 ausgebildet wird. In der Praxis ist es nicht möglich, absolut identische Verfahrensbedingungen für die beiden genannten Verfahrensschritte einzustellen. Es ist jedoch wichtig, in dem Logik-Bereich einerseits und in dem Speicher-Bereich andererseits Strukturen mit einer homogenen Flächenbelegungsdichte bereitzustellen. Die Flächenbelegungsdichte ist definiert als das Verhältnis der Summe der jeweils im Logik- bzw. Speicher-Bereich abgedeckten Flächen dividiert durch die Gesamtfläche des Logik-Bereichs bzw. des Speicher-Bereichs. Idealerweise sollte die Flächenbelegungsdichte über dem gesamten Chip möglichst homogen sein, um minimale Toleranzen bei der Herstellung der Gate-Elektroden gewährleisten zu können.

Weichen die Flächenbelegungsdichten bei den beiden beschriebenen Verfahrensschritten zum Strukturieren der Logik-Transistoren einerseits und der Speicher-Transistoren andererseits voneinander ab, so erhält man eine Variation in der Geometrie der Gate-Elektrode. Aus einer ungleichmäßigen Flächenbelegungsdichte resultierende nachteilige Effekte werden als Ätzloading-Effekte bezeichnet. Diese wirken sich auf die Funktionalität des ausgebildeten integrierten Schaltkreises nachteilig aus. Daher ist die Qualität der Transistoren, die gemäß dem beschriebenen Verfahren hergestellt sind, häufig schlecht.
[2] offenbart eine CMOS-Halbleitervorrichtung mit einem p-MOS-Transistor und mit einem n-MOS-Transistor auf einem Wafer.
[3] offenbart ein Verfahren zum Herstellen einer Halbleitervorrichtung, das Ätzen eines Feldoxids erlaubt, wobei eine Schädigung des Siliziums minimiert ist.
[4] offenbart ein Verfahren zum Herstellen einer Halbleiterspeichervorrichtung mit n-MOS- und p-MOS-Transistoren mit unterschiedlichen Eigenschaften.
[5] offenbart eine Halbleitervorrichtung mit einer DRAM-Zelle.

Weitere Verfahren und Bauelemente sind in den Dokumenten US6037222, EP0305741 u. US5933730 beschrieben.

Der Erfindung liegt das Problem zugrunde, mit verringertem Aufwand und in verbesserter Qualität lateral begrenzte Schichtenfolgen mit unterschiedlichen Seitenwand-Dicken auf einem gemeinsamen Substrat zu schaffen.

Das Problem wird durch ein Verfahren zum Herstellen einer Schicht-Anordnung, durch eine Schicht-Anordnung und durch eine Speicher-Anordnung mit den Merkmalen gemäß den unabhängigen Patentansprüchen 1,6,10 gelöst.

Erfindungsgemäß ist ein Verfahren zum Herstellen einer Schicht-Anordnung geschaffen, bei dem mindestens eine jeweils lateral begrenzte, erste Schichtenfolge auf einem ersten Oberflächen-Bereich eines Substrats und mindestens eine jeweils lateral begrenzte zweite Schichtenfolge auf einem zweiten Oberflächen-Bereich des Substrats ausgebildet wird. Ferner wird jeweils eine erste Seitenwand-Schicht einer ersten Dicke aus einem ersten elektrisch isolierenden Material auf zumindest einem Teilbereich der Seitenwände der ersten und zweiten Schichtenfolge ausgebildet. Darüber hinaus wird jeweils eine zweite Seitenwand-Schicht einer zweiten Dicke aus einem zweiten elektrisch isolierenden Material auf zumindest einem Teilbereich der ersten Seitenwand-Schichten der ersten und zweiten Schichtenfolge ausgebildet. Anschließend werden die zweiten Seitenwand-Schichten von den ersten Schichtenfolgen entfernt.

Anschaulich ist dadurch eine vereinfachte Prozessführung insbesondere bei der Herstellung von Gate-Elektroden mit unterschiedlicher Seitenwandoxid-Dicke ermöglicht.

Die erste Schichtenfolge auf dem ersten Oberflächen-Bereich des Substrats kann ein Logik-Transistor eines Logik-Schaltkreises sein, und die zweite Schichtenfolge kann ein Speicher-Transistor in einem Speicher-Bereich eines integrierten Schaltkreises sein. Bei der erfindungsgemäß hergestellten Schicht-Anordnung ist die Dicke des Seitenwandoxids der ersten lateral begrenzten Schichtenfolge (Schicht der ersten Dicke) geringer als die Dicke der Seitenwand-Schicht auf der zweiten lateral begrenzten Schichtenfolge (Schicht der ersten Dicke plus Schicht der zweiten Dicke). Die erste Schichtenfolge, die vorzugsweise einen Logik-Transistor in dem Logik-Bereich eines integrierten Schaltkreises bildet, weist infolge der geringen Dicke des Seitenwandoxids einen ausreichend niederohmigen Anschlusswiderstand auf und gewährleistet eine ausreichend schnelle Logik. Dagegen weist die zweite Schichtenfolge eine dickere Seitenwand-Schicht auf, woraus eine Reihe vorteilhafter Wirkungen resultiert: ein Speicher-Transistor mit einer hohen Seitenwandoxid-Dicke weist eine ausreichend große Haltezeit der gespeicherten Information auf, ferner bewirkt eine ausreichend dicke Seitenwandoxid-Schicht einen guten Schutz eines Speicher-Transistors gegenüber einem störenden Einfluss der Umgebung.

Gemäß einer vorteilhaften Ausgestaltung des Verfahrens weist das Ausbilden von mindestens einer jeweils lateral begrenzten ersten Schichtenfolge auf dem ersten Oberflächen-Bereich des Substrats und das Ausbilden der mindestens einen jeweils lateral begrenzten zweiten Schichtenfolge auf dem zweiten Oberflächen-Bereich des Substrats folgende Teilschritte auf:

In einem ersten Teilschritt wird eine erste elektrisch isolierende Hilfsschicht auf dem ersten und dem zweiten Oberflächen-Bereich des Substrats, eine zweite elektrisch leitfähige Hilfsschicht auf der ersten elektrisch isolierenden Hilfsschicht und eine dritte elektrisch isolierende Hilfsschicht auf der zweiten elektrisch leitfähigen Hilfsschicht ausgebildet. In einem zweiten Teilschritt werden die erste, die zweite und die dritte Hilfsschicht von dem ersten Oberflächen-Bereich des Substrats entfernt. In einem dritten Teilschritt wird eine vierte elektrisch isolierende Hilfsschicht auf dem ersten und dem zweiten Oberflächen-Bereich des Substrats (genauer gesagt auf der Oberfläche der Schichtstruktur, wie sie nach dem zweiten Teilschritt erhalten wird), eine fünfte elektrisch leitfähige Hilfsschicht auf der vierten elektrisch isolierenden Hilfsschicht und eine sechste elektrisch isolierende Hilfsschicht auf der fünften elektrisch leitfähigen Hilfsschicht ausgebildet. In einem vierten Teilschritt werden die fünfte und die sechste Hilfsschicht auf dem ersten und dem zweiten Oberflächen-Bereich gemeinsam derart strukturiert, dass auf dem ersten Oberflächen-Bereich die mindestens eine lateral begrenzte erste Schichtenfolge gebildet wird. In einem fünften Teilschritt werden auf dem zweiten Oberflächen-Bereich die zweite, die dritte und die vierte Hilfsschicht derart strukturiert, dass dadurch die mindestens eine jeweils lateral begrenzte zweite Schichtenfolge auf dem zweiten Oberflächen-Bereich gebildet wird.

Hervorzuheben ist, dass in dem vierten Teilschritt die fünfte und die sechste Hilfsschicht auf dem ersten und dem zweiten Oberflächen-Bereich gemeinsam strukturiert werden. Mit anderen Worten werden in diesem Teilschritt die auf dem Oberflächen-Bereich abgeschiedenen Schichtenfolgen derart strukturiert, dass dadurch in einem gemeinsamen Verfahrensschritt die laterale Begrenzung der ersten und zweiten Schichtenfolgen definiert wird. Mit anderen Worten werden bezugnehmend auf ein bevorzugtes Ausführungsbeispiel, bei dem die ersten Schichtenfolgen Logik-Transistoren und die zweiten Schichtenfolgen Speicher-Transistoren eines integrierten Schaltkreises sind, sowohl die Logik-Transistoren als auch die Speicher-Transistoren in einem einzigen, gemeinsamen kritischen Lithographieschritt strukturell definiert. Dadurch ist gegenüber dem oben bezugnehmend auf **Fig.1A** bis **Fig.1I** beschriebenen Verfahren zum Ausbilden von Logik-Transistoren und Speicher-Transistoren mit unterschiedlichen Seitenwanddicken ein kritischer Lithographieschritt eingespart, wodurch das Herstellungsverfahren von Logik-Transistoren bzw. Speicher-Transistoren mit unterschiedlichen Seitenwanddicken wesentlich vereinfacht ist. Dadurch sind die Herstellungskosten reduziert und der Aufwand vermindert.

Ferner bewirkt das gemeinsam durchgeführte Strukturieren der Logik-Transistoren und der Speicher-Transistoren, dass Ätzloading-Effekte infolge inhomogener Flächenbelegungsdichten auf unterschiedlichen Oberflächen-Bereichen des Substrats (siehe obige Beschreibung) vermindert sind. Anschaulich ist die Gleichmäßigkeit der Flächenbelegungsdichte der ersten und zweiten Schichtenfolgen verbessert, da die Verfahrensparameter beim Ausbilden der ersten bzw. der zweiten Schichtenfolgen infolge des gemeinsamen Lithographieschrittes identisch sind. Wesentliche Parameter der Schichtenfolgen, beispielsweise die Länge des Gateoxid-Bereichs der MOS-Transistoren, sind daher für die Logik- und Speicher-Transistoren einheitlich, so dass ein integrierter Schaltkreis mit Logik-Bereich und Speicher-Bereich, der gemäß dem erfindungsgemäßen Verfahren hergestellt ist, eine gegenüber dem Stand der Technik verbesserte Qualität aufweist.

Gemäß einer vorteilhaften Ausgestaltung des erfindungsgemäßen Herstellungsverfahrens werden zwischen dem Ausbilden der zweiten Seitenwand-Schicht der zweiten Dicke aus dem zweiten elektrisch isolierendem Material auf zumindest einem Teilbereich der ersten Seitenwand-Schichten der ersten und zweiten Schichtenfolge einerseits und dem Entfernen der zweiten Seitenwand-Schichten von den ersten Schichtenfolgen andererseits in Oberflächen-Bereiche, die an die seitlichen Endabschnitte der zweiten Schichtenfolgen angrenzen, Dotierungsatome eingebracht.

Mit anderen Worten werden in diesem Verfahrensschritt LDD-Bereiche in den an die seitlichen Randbereiche der zweiten Schichtenfolgen angrenzenden Oberflächen-Bereiche des Substrats ausgebildet. Dieser Verfahrensschritt zielt darauf ab, den ersten bzw. den zweiten Source-/Drain-Bereich der zweiten Schichtenfolgen in einem Szenario auszubilden, in dem die zweiten Schichtenfolgen Speicher-Transistoren sind.

Gemäß einer Weiterbildung der Erfindung werden nach dem Entfernen der zweiten Seitenwand-Schichten von den ersten Schichtenfolgen in Oberflächen-Bereiche des Substrats, die von den seitlichen Randabschnitten der zweiten Schichtenfolgen räumlich entkoppelt sind, und die mit einem der Oberflächen-Bereiche des Substrats teilweise überlappen, in die Dotierungsatome eingebracht worden sind, Dotierungsatome eingebracht.

Dieser Verfahrensschritt stellt das Ausbilden von HDD-Bereichen ("highly doped drain") dar, die mit den oben beschriebenen LDD-Bereichen ("lightly doped drain") überlappend ausgebildet werden. Die Konzentration der Dotierungsatome ist in den LDD-Bereichen geringer als in den HDD-Bereichen. Die Dotierungsatome können Dotierungsatome des n-Typs oder Dotierungsatome des p-Typs sein.

Gemäß einer weiteren Ausgestaltung der Erfindung werden nach dem Entfernen der zweiten Seitenwand-Schichten von den ersten Schichtenfolgen in Oberflächen-Bereiche des Substrats, die an seitliche Randabschnitte der ersten Schichtenfolgen angrenzen, Dotierungsatome eingebracht.

Wie oben beschrieben, werden die ersten Schichtenfolgen insbesondere als Logik-Transistoren in einem Logik-Bereich eines integrierten Schaltkreises verwendet. In dem beschriebenen Verfahrensschritt wird der erste Source-/Drain-Bereich und der zweite Source-/Drain-Bereich der Logik-Transistoren ausgebildet. Die hierbei in Oberflächen-Bereiche des Substrats, die an die seitlichen Randbereiche der ersten Schichtenfolge angrenzen, eingebrachten Dotierungsatome können n-Dotierungsatome oder p-Dotierungsatome sein.

Die beschriebenen Verfahrensschritte sind alle mit standardisierten halbleitertechnologischen Verfahren wie dem Ionenimplantations-Verfahren, bekannten Lithographie- und bekannten Ätz-Verfahren, sowie bekannten Abscheideverfahren wie beispielsweise das CVD-Verfahren ("chemical vapour deposition") realisierbar. Daher ist das erfindungsgemäße Herstellungsverfahren wenig aufwändig und technologisch einfach.

Gemäß einem anderen Verfahren zum Herstellen einer Schicht-Anordnung wird mindestens eine jeweils lateral begrenzte erste Schichtenfolge auf einem ersten Oberflächen-Bereich eines Substrats und mindestens eine jeweils lateral begrenzte zweite Schichtenfolge auf einem zweiten Oberflächen-Bereich des Substrats ausgebildet. Ferner wird jeweils eine erste Seitenwand-Schicht einer ersten Dicke aus einem ersten elektrisch isolierenden Material auf zumindest einem Teil-Bereich der Seitenwände der ersten und zweiten Schichtenfolge ausgebildet. Darüber hinaus wird eine Hilfs-Seitenwand-Schicht auf zumindest einem Teil-Bereich der ersten Seitenwand-Schichten der ersten Schichtenfolge ausgebildet, und es wird eine zweite Seitenwand-Schicht einer zweiten Dicke aus einem zweiten elektrisch isolierenden Material auf zumindest einem Teil-Bereich der ersten Seitenwand-Schicht der zweiten Schichtenfolge ausgebildet. Das Material der Hilfs-Seitenwand-Schicht wird derart gewählt, dass während des Ausbildens der zweiten Seitenwand-Schicht auf zumindest einem Teil-Bereich der ersten Seitenwand-Schicht der zweiten Schichtenfolge die Hilfs-Seitenwand-Schicht von einer Bedeckung mit dem zweiten elektrisch isolierenden Material frei bleibt.

Anschaulich wird mittels Aufbringens der Hilfs-Seitenwand-Schicht die erste Schichtenfolge vor einer Bedeckung mit der zweiten Seitenwand-Schicht geschützt. Nach dem Aufbringen der zweiten Seitenwand-Schicht auf die zweite Schichtenfolge kann die Hilfs-Seitenwand-Schicht entfernt werden, wodurch auf der Seitenwand der ersten Schichtenfolge lediglich die erste Seitenwand-Schicht und auf der Seitenwand des zweiten Schichtenstapels die erste und die zweite Seitenwand-Schicht zurückbleibt.

Vorzugsweise wird nach dem Ausbilden der zweiten Seitenwand-Schicht die Hilfs-Seitenwand-Schicht von dem ersten Schichtenstapel entfernt.

Gemäß einer bevorzugten Ausgestaltung wird die zweite Seitenwand-Schicht mittels thermischen Oxidierens zumindest eines Teils des Materials der zweiten lateral begrenzten Schichtenfolge ausgebildet. Dieses thermische Oxidieren wirkt infolge geeigneter Materialwahl anschaulich "durch" die erste Seitenwand-Schicht hindurch. Anschaulich schützt während des thermischen Oxidierens die Hilfs-Seitenwand-Schicht die erste Schichtenfolge vor thermischem Oxidieren.

Vorzugsweise sind das erste und das zweite elektrisch isolierende Material Siliziumdioxid und ist das Material der Hilfs-Seitenwand-Schicht Siliziumnitrid.

Im Weiteren wird die erfindungsgemäße Schicht-Anordnung näher beschrieben. Ausgestaltungen der Schicht-Anordnung gelten auch für die Verfahren zum Herstellen einer Schicht-Anordnung.

Die erfindungsgemäße Schicht-Anordnung weist ein Substrat, mindestens eine jeweils lateral begrenzte erste Schichtenfolge auf einem ersten Oberflächen-Bereich des Substrats, mindestens eine jeweils lateral begrenzte zweite Schichtenfolge auf einem zweiten Oberflächen-Bereich des Substrats, jeweils eine erste Seitenwand-Schicht einer ersten Dicke aus einem ersten elektrisch isolierenden Material auf zumindest einem Teilbereich jeder der Seitenwände jeder der ersten und zweiten Schichtenfolgen und jeweils eine zweite Seitenwand-Schicht einer zweiten Dicke aus einem zweiten elektrisch isolierenden Material auf zumindest einem Teilbereich jeder der ersten Seitenwand-Schichten jeder der zweiten Schichtenfolgen auf.

Insbesondere kann die erste Dicke kleiner als die zweite Dicke sein. Die erste Dicke ist vorzugsweise zwischen 5nm und 7nm, wohingegen die zweite Dicke vorzugsweise ungefähr 10nm oder größer ist.

Das Substrat ist vorzugsweise ein Silizium-Substrat wie beispielsweise ein Silizium-Wafer oder Silizium-Chip.

Zwischen dem Substrat und zumindest einem Teil der ersten und/oder der zweiten Schichtenfolge kann auf zumindest einem Teil der Oberfläche des Substrats eine Isolationsschicht aus einem dritten elektrisch isolierenden Material angeordnet sein.

Bezugnehmend auf die Verwendung der erfindungsgemäßen Schicht-Anordnung als Logik-Bereich (erste Schichtenfolgen) bzw. Speicher-Bereich (zweite Schichtenfolgen) kann die zwischen den Schichtenfolgen und dem Substrat angeordnete Isolationsschicht die Gateoxid-Schicht der von den Schichtenfolgen gebildeten Transistoren bilden.

Gemäß einer vorteilhaften Ausgestaltung der erfindungsgemäßen Schicht-Anordnung weist die erste Schichtenfolge eine erste Teilschicht aus einem ersten elektrisch leitfähigen Material und eine zweite Teilschicht aus einem vierten elektrisch isolierendem Material auf.

Die zweite Schichtenfolge weist vorzugsweise eine Ladungsspeicher-Teilschicht, eine zweite Teilschicht aus einem fünften elektrisch isolierenden Material, eine dritte Teilschicht aus einem zweiten elektrisch leitfähigen Material und eine vierte Teilschicht aus einem sechsten elektrisch isolierenden Material auf.

Insbesondere kann die Ladungsspeicher-Teilschicht eine Schicht aus polykristallinem Silizium mit einer Siliziumdioxid-Siliziumnitrid-Siliziumdioxid-Schichtenfolge (ONO-Schicht) als Deckschicht sein. Alternativ kann die Ladungsspeicher-Teilschicht eine Siliziumdioxid-Siliziumnitrid-Siliziumdioxid-Schichtenfolge (ONO-Schicht) sein.

Die beiden beschriebenen Alternativen entsprechen zwei unterschiedlichen Konzepten von Speicher-Transistoren, nämlich Speicher-Transistoren nach dem Floating-Gate-Prinzip und Speicher-Transistoren mit einer ONO-Schicht als Ladungsspeicher-Schicht. Sowohl Floating-Gate Speicher-Transistoren als auch ONO-Schicht Speicher-Transistoren können als zweite Schichtenfolgen der erfindungsgemäßen Schicht-Anordnung dienen.

Bei einem ONO-Speicher-Transistor ist die Gateoxid-Schicht durch eine ONO-Schicht (Siliziumdioxid-Siliziumnitrid-Siliziumdioxid) ersetzt, wobei mittels "channel hot electron injection" (CHE) Ladungsträger in die ONO-Schicht (genauer gesagt in die Siliziumnitrid-Schicht der ONO-Schicht) injiziert werden können, die dort dauerhaft verbleiben. In Abhängigkeit der Anzahl der in der ONO-Schicht eingebrachten Elektronen weist der Gate-Bereich eines ONO-Transistors eine unterschiedliche elektrische Leitfähigkeit auf. Dadurch ist in der ONO-Schicht die Speicherinformation kodiert.

Dagegen ist bei einem Floating-Gate Speicher-Transistor zwischen der Gate-Elektrode und der Gateoxid-Schicht eine Schicht aus einem elektrisch leitfähigen Material, z.B. aus polykristallinem Silizium, und eine ausreichend dicke Schicht aus einem elektrisch isolierenden Material eingebracht. Mittels Anlegens einer ausreichend hohen elektrischen Spannung zwischen der Gate-Elektrode und der Source-/Drain-Bereiche können mittels Fowler-Nordheim-Tunnelns oder heißer Ladungsträger in die elektrisch leitfähige Schicht oberhalb der Gateoxid-Schicht Ladungsträger injiziert werden, deren Anwesenheit die elektrische Leitfähigkeit des Kanalbereichs unterhalb des Gateoxids zwischen dem Source-Bereich und dem Drain-Bereich eines derartigen Transistors verändert. Der Wert dieser Leitfähigkeit kodiert die in dem Floating-Gate Speicher-Transistor gespeicherte Information.

Die erfindungsgemäß bereitgestellte Schicht-Anordnung weist den Vorteil auf, dass die darin enthaltenen zweiten Schichtenfolgen wahlweise als Floating-Gate-Transistor, als ONO-Transistor oder als ein Speicher-Transistor einer anderen Art ausgestaltet werden können. Daher ist die erfindungsgemäße Schicht-Anordnung einfach und flexibel auf die Bedürfnisse des Einzelfalls anpassbar.

Das erste und/oder das zweite elektrisch leitfähige Material ist vorzugsweise polykristallines Silizium.

Das erste, das zweite, das dritte, das vierte, das fünfte und das sechste elektrisch isolierende Material können Siliziumdioxid oder Siliziumnitrid oder eine Siliziumdioxid-Siliziumnitrid-Siliziumdioxid Schichtenfolge (ONO-Schicht) sein.

Mit anderen Worten kann eine ONO-Schicht nicht nur, wie oben beschrieben, als Schicht zum Einspeichern von Ladungsträgern, deren Anzahl die in einem Speicher-Transistor gespeicherte logische Information kodiert, sondern auch als eine Schicht mit elektrisch isolierenden Eigenschaften verwendet werden, beispielsweise zum Entkoppeln zweier elektrisch leitfähiger Bereiche.

Schließlich ist erfindungsgemäß eine Speicher-Anordnung mit einer Schicht-Anordnung mit den Merkmalen gemäß der obigen Beschreibung bereitgestellt. Bei der erfindungsgemäßen Speicher-Anordnung bildet die mindestens eine erste Schichtenfolge auf dem ersten Oberflächen-Bereich des Substrats mindestens einen Teil des Logik-Bereichs der Speicher-Anordnung, wohingegen die mindestens eine zweite Schichtenfolge auf dem zweiten Oberflächen-Bereich des Substrats mindestens einen Teil des Speicherzellen-Bereichs der Speicher-Anordnung bildet.

Zusammenfassend realisiert die Erfindung das Bedürfnis nach unterschiedlich dicken Seitenwandoxid-Schichten in Logik-Transistoren und in Speicher-Transistoren in einem gemeinsamen integrierten Schaltkreis, der mit nur einer kritischen Gatestrukturierung herstellbar ist. Daher ist das Verfahren zum Herstellen einer derartigen Schicht-Anordnung wesentlich einfacher und kostengünstiger als das aus dem Stand der Technik bekannte Verfahren. Ferner wird verfahrensgemäß eine homogene Flächenbelegung erreicht, was sich auf die Reproduzierbarkeit und die Qualität der Gatestrukturierung vorteilhaft auswirkt. Außerdem werden dadurch Ätzloading-Effekte vermieden.

Anschaulich kann ein Aspekt der Erfindung darin gesehen werden, dass sowohl die ersten Schichtenfolgen als auch die zweiten Schichtenfolgen mit einer dünnen Seitenwandoxid-Schicht bedeckt werden und anschließend die ersten und die zweiten Schichtenfolgen mit einer zweiten, vorzugsweise dickeren Seitenwandoxid-Schicht bedeckt werden, welche zweite Seitenwandoxid-Schicht anschließend von dem Logik-Bereich entfernt wird.

Ausführungsbeispiele der Erfindung sind in den Figuren dargestellt und werden im Weiteren näher erläutert.

Es zeigen:
- Figuren 1A bis 1I: Querschnittsansichten von Schichtstrukturen zu unterschiedlichen Zeitpunkten während eines Herstellungsverfahrens gemäß dem Stand der Technik,
- Figuren 2A bis 2J: Querschnittsansichten von Schichtstrukturen zu unterschiedlichen Zeitpunkten während eines Herstellungsverfahrens gemäß einem bevorzugten Ausführungsbeispiel des erfindungsgemäßen Verfahrens zum Herstellen einer Schicht-Anordnung,
- Figuren 3A bis 3E: Querschnittsansichten von Schichtstrukturen zu unterschiedlichen Zeitpunkten während eines Herstellungsverfahrens gemäß einem anderen bevorzugten Ausführungsbeispiel des erfindungsgemäßen Verfahrens zum Herstellen einer Schicht-Anordnung.

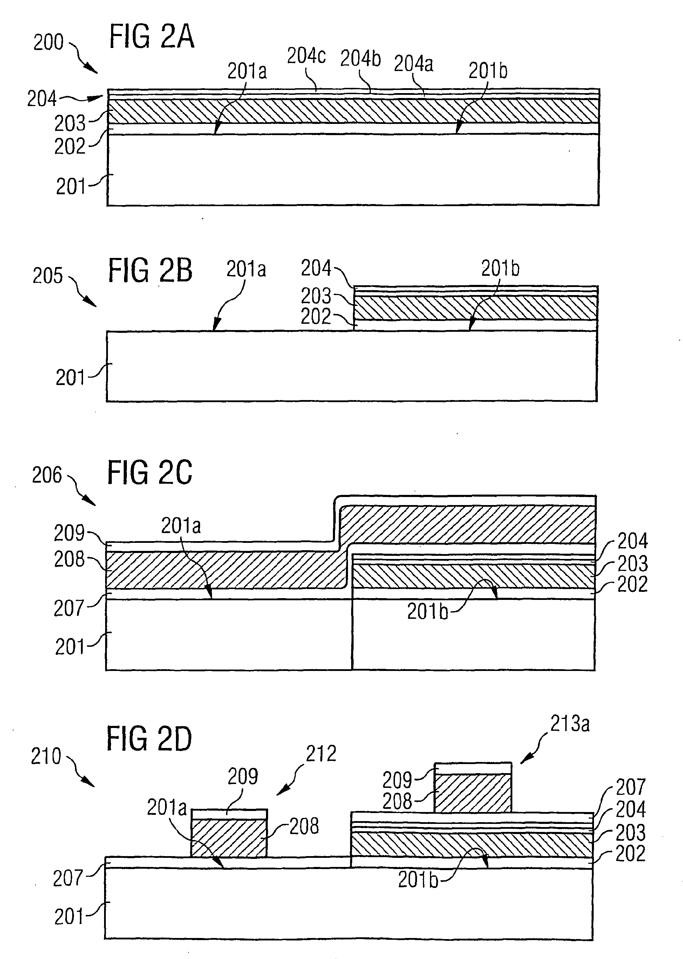

Im Weiteren wird bezugnehmend auf **Fig.2A** bis **Fig.2J** ein bevorzugtes Ausführungsbeispiel des erfindungsgemäßen Verfahrens zum Herstellen einer Schicht-Anordnung beschrieben.

In **Fig.2A** bis **Fig.2J** ist jeweils eine gestrichelte vertikale Trennlinie eingezeichnet. Diese trennt einen jeweils links der Trennlinie gezeigten ersten Oberflächen-Bereich 201a eines Substrats 201, auf dem erste Schichtenfolgen zum Bilden von Logik-Transistoren ausgebildet werden, von einem jeweils rechts der Trennlinie gezeigten zweiten Oberflächen-Bereich 201b des Substrats 201, auf dem zweite Schichtenfolgen zum Bilden von Speicher-Transistoren ausgebildet werden. In den Figuren sind zum Zwecke einer vereinfachten Erklärung nur eine erste Schichtenfolge auf dem ersten Oberflächen-Bereich 201a und nur eine zweite Schichtenfolge auf dem zweiten Oberflächen-Bereich 201b gezeigt. In der Praxis werden häufig jeweils eine Vielzahl von Schichtenfolgen auf den jeweiligen Oberflächen-Bereichen 201a, 201b ausgebildet.

Die in **Fig.2A** gezeigte Schichtstruktur 200 wird erhalten, indem auf einem ersten Oberflächen-Bereich 201a und auf einem zweiten Oberflächen-Bereich 201b eines Silizium-Wafers 201 eine erste Siliziumdioxid-Schicht 202, eine erste Poly-Silizium-Schicht 203 auf der ersten Siliziumdioxid-Schicht 202 und eine ONO-Schicht 204 auf der ersten Poly-Silizium-Schicht 203 ausgebildet werden. Die ONO-Schicht 204 weist eine Siliziumdioxid-Teilschicht 204a, eine Siliziumnitrid-Teilschicht 204b und eine weitere Siliziumdioxid-Teilschicht 204c auf. Die Siliziumdioxid-Teilschicht 204a der ONO-Schicht 204 wird auf der ersten Poly-Silizium-Schicht 203 ausgebildet, die Siliziumnitrid-Teilschicht 204b wird auf der Siliziumdioxid-Teilschicht 204a und die weitere Siliziumdioxid-Teilschicht 204c wird auf der Siliziumnitrid-Teilschicht 204b ausgebildet.

Das Ausbilden der ersten Siliziumdioxid-Schicht 202, der ersten Poly-Silizium-Schicht 203 bzw. der ONO-Schicht 204 erfolgt gemäß dem beschriebenen Ausführungsbeispiel unter Verwendung von thermischer Oxidation oder von CVD-Verfahren ("chemical vapour deposition").

Um auf die in **Fig.2B** gezeigte Schichtstruktur 205 zu gelangen, werden die erste Siliziumdioxid-Schicht 202, die erste Poly-Silizium-Schicht 203 und die ONO-Schicht 204 von dem ersten Oberflächen-Bereich 201a des Silizium-Wafers 201 entfernt.

Dieser Verfahrensschritt wird gemäß dem beschriebenen Ausführungsbeispiel realisiert, indem mittels einer geeigneten Maske der zweite Oberflächen-Bereich der Schichtstruktur 200 abgedeckt wird und mittels eines Lithographie- und eines Ätz-Verfahrens die erste Siliziumdioxid-Schicht 202, die erste Poly-Silizium-Schicht 203 und die ONO-Schicht 204 von dem ersten Oberflächen-Bereich 201a der Schichtstruktur 200 entfernt wird. Der erste Oberflächen-Bereich 201a stellt den späteren Logik-Bereich dar, wohingegen der zweite Oberflächen-Bereich 201b den späteren Speicher-Bereich eines integrierten Schaltkreises bildet. Es ist zu betonen, dass der Lithographie-Verfahrensschritt, der erforderlich ist, um von der Schichtstruktur 200 auf die Schichtstruktur 205 zu gelangen, unkritisch ist, d.h., dass geringfügige strukturelle Ungenauigkeiten beim Durchführen des Lithographie-Verfahrens für die Funktionalität des erhaltenen integrierten Schaltkreises keine gravierenden Folgen haben. Daher ist dieser Verfahrensschritt wenig aufwändig.

Um auf die in **Fig.2C** gezeigte Schichtstruktur 206 zu gelangen, wird eine zweite Siliziumdioxid-Schicht 207 auf dem ersten und dem zweiten Oberflächen-Bereich 201a, 201b des Silizium-Wafers 201 (genauer gesagt wird diese Schicht nicht auf dem zweiten Oberflächen-Bereich 201b selbst, sondern auf der Oberfläche der obersten der auf dem zweiten Oberflächen-Bereich 201b angeordneten Schichten abgeschieden), eine zweite Poly-Silizium-Schicht 208 auf der zweiten Siliziumdioxid-Schicht 207 und eine Siliziumnitrid-Hartmaske 209 auf der zweiten Poly-Silizium-Schicht 208 abgeschieden.

Auch diese Verfahrensschritte werden unter Verwendung des CVD-Verfahrens realisiert, d.h. es werden die Schichten 207, 208, 209 aus der Gasphase abgeschieden.

Die in **Fig.2D** gezeigte Schichtstruktur 210 wird erhalten, indem die zweite Poly-Silizium-Schicht 208 und die Siliziumnitrid-Hartmaske 209 auf dem ersten und dem zweiten Oberflächen-Bereich 201a, 201b gemeinsam derart strukturiert werden, dass auf dem ersten Oberflächen-Bereich eine lateralbegrenzte, erste Schichtenfolge 212 gebildet wird. Auf dem zweiten Oberflächen-Bereich 201b wird dadurch eine lateral begrenzte Hilfs-Schichtenfolge 213a gebildet.

Um diesen Verfahrensschritt zu realisieren, wird auf die gesamte Oberfläche der Schichtstruktur 206 ein Lithographie- und ein Ätz-Verfahren angewendet. Da bei diesen Lithographie- und bei diesem Ätz-Verfahren lateral begrenzte Strukturen gebildet werden, deren Dimension äußerst gering ist, (größenordnungsmäßig in der Dimension von 100nm und weniger) ist dieser Lithographieschritt kritisch. Das bedeutet, dass sich geringe Fehler bei diesem Verfahrensschritt auf die Funktionalität des hergestellten integrierten Schaltkreises sensitiv auswirken. Daher ist bei diesem Verfahrensschritt eine besondere Aufmerksamkeit erforderlich. Es ist zu betonen, dass dieser Verfahrensschritt den einzigen kritischen Lithographie-Schritt im Rahmen des erfindungsgemäßen Herstellungsverfahrens darstellt. Die Tatsache, dass beim Ausbilden der lateral begrenzten Bereiche 212, 213a in dem ersten und dem zweiten Oberflächen-Bereich dieselben Prozessbedingungen vorliegen, sind Schwankungen in den physikalischen Parametern der ausgebildeten Strukturen vermieden. Insbesondere ist die Flächenbelegungsdichte homogen.

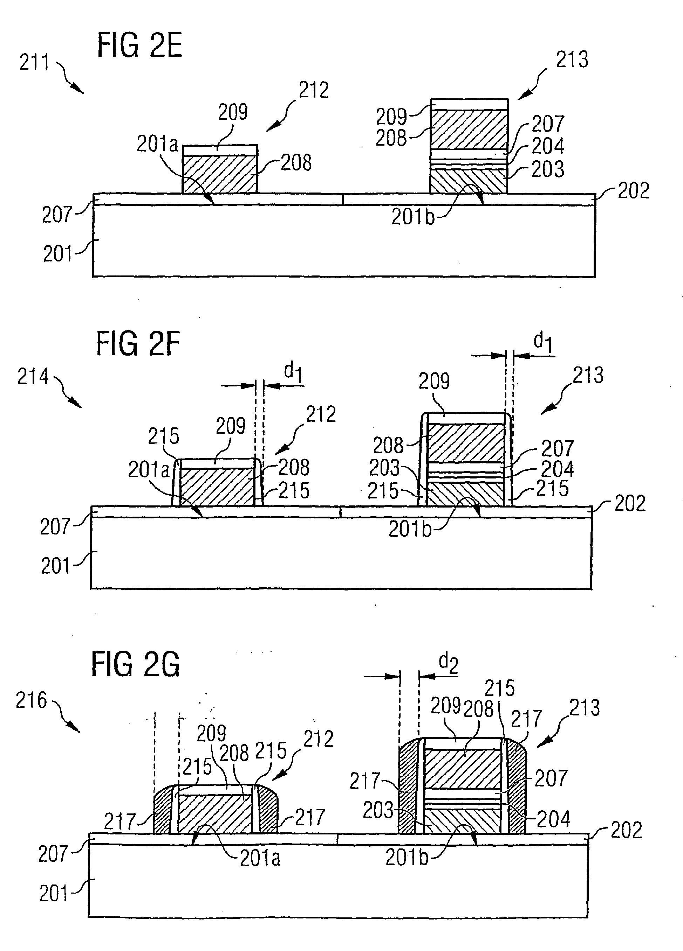

Um von der in Fig.2D gezeigten Schichtstruktur 210 auf die in Fig.2E gezeigte Schichtstruktur 211 zu gelangen, werden auf dem zweiten Oberflächen-Bereich 201b des Silizium-Wafers 201 die erste Poly-Silizium-Schicht 203, die ONO-Schicht 204 und die zweite Siliziumdioxid-Schicht 207 derart strukturiert, dass dadurch eine jeweils lateral begrenzte zweite Schichtenfolge 213 auf dem zweiten Oberflächen-Bereich 201b gebildet wird.

Bei diesem unkritischen Lithographie-Verfahrensschritt ist der erste Oberflächen-Bereich 201a, der spätere Logik-Bereich, mit einer Maske abgedeckt. Dies bedeutet, dass der Verfahrensschritt nur auf den zweiten Oberflächen-Bereich 201b der Schichtstruktur 210 angewandt wird. Die Strukturierung der Schichten 203, 204, 207 auf dem zweiten Oberflächen-Bereich 201b erfolgt unter Verwendung eines geeigneten Ätz-Verfahrens, das derart gewählt wird, dass die laterale Begrenzung der Hilfs-Schichtenfolge 213a auch die laterale Begrenzung beim Zurückätzen der Schichten 203, 204, 207 auf dem zweiten Oberflächen-Bereich 201b definiert. Mit anderen Worten erfolgt ein anisotropes Ätzen in einer gemäß **Fig.2E** vertikalen Richtung, wodurch die laterale Begrenzung, die durch die Hilfs-Schichtenfolge 213a definiert ist, sich anschaulich nach unten fortsetzt. Daher ist die laterale Begrenzung der zweiten lateral begrenzten Schichtenfolge 213 durch den oben beschriebenen kritischen Lithographie-Schritt festgelegt.

Die bezugnehmend auf **Fig.2A** bis **Fig.2E** beschriebenen Verfahrensschritte können dahingehend zusammengefasst werden, dass eine lateral begrenzte erste Schichtenfolge 212 auf dem ersten Oberflächen-Bereich 201a des Silizium-Wafers 201 und eine lateral begrenzte zweite Schichtenfolge 213 auf dem zweiten Oberflächen-Bereich 201b des Silizium-Wafers 201 ausgebildet werden.

Um von der in **Fig.2E** gezeigten Schichtstruktur 211 auf die in **Fig.2F** gezeigte Schichtstruktur 214 zu gelangen, wird jeweils eine erste Siliziumdioxid-Seitenwand-Schicht 215 einer ersten Dicke d₁ auf den Seitenwänden der ersten Schichtenfolge 212 und der zweiten Schichtenfolge 213 ausgebildet.

Dieser Verfahrensschritt ist gemäß dem beschriebenen Ausführungsbeispiel realisiert, indem die Seitenwände der ersten lateral begrenzten Schichtenfolge 212 und der zweiten lateral begrenzten Schichtenfolge 213 thermisch oxidiert werden. Thermisches Oxidieren bedeutet, dass in der Verfahrenskammer eine Sauerstoff-Atmosphäre erzeugt wird und die Reaktivität des Sauerstoffs mittels Temperaturerhöhung heraufgesetzt wird. Als Folge davon werden die Silizium aufweisenden Seitenwände der lateral begrenzten Schichtenfolgen 212, 213 zu Siliziumdioxid oxidiert. Dadurch wird eine erste Siliziumdioxid-Seitenwand-Schicht 215 erhalten, deren erste Dicke d₁ ungefähr 5nm ist.

Die in **Fig.2G** gezeigte Schichtstruktur 216 wird erhalten, indem jeweils eine zweite Siliziumdioxid-Seitenwand-Schicht 217 einer zweiten Dicke d₂ auf den ersten Siliziumdioxid-Seitenwand-Schichten 215 der ersten Schichtenfolge 212 und der zweiten Schichtenfolge 213 ausgebildet wird.

Gemäß dem beschriebenen bevorzugten Ausführungsbeispiel des erfindungsgemäßen Verfahrens zum Herstellen einer Schicht-Anordnung ist die zweite Siliziumdioxid-Seitenwand-Schicht 217 aus Siliziumdioxid. Die zweite Siliziumdioxid-Seitenwand-Schicht 217 wird auf die ersten Siliziumdioxid-Seitenwand-Schichten 215 unter Verwendung des CVD-Verfahrens aufgebracht.

Gemäß dem beschriebenen Ausführungsbeispiel ist die zweite Dicke d₂ größer als die erste Dicke d₁, d.h. d₂>d₁.

Es ist zu betonen, dass abweichend von dem beschriebenen Ausführungsbeispiel die zweiten Seitenwand-Schichten auch aus Siliziumnitrid-Material hergestellt werden können, die auf die ersten Siliziumdioxid-Seitenwand-Schichten 215 ebenfalls mittels eines CVD-Verfahrens aufgebracht werden können.

Gemäß dem beschriebenen Ausführungsbeispiel werden die zweiten Siliziumdioxid-Seitenwand-Schichten 217 auf den ersten Siliziumdioxid-Seitenwand-Schichten 215 gemäß einem speziellen CVD-Verfahren, dem sogenannten TEOS-Verfahren (Tetra-Ethyl-Ortho-Silikat), ausgebildet. Um eine hohe Nassätzrate der zweiten Siliziumdioxid-Seitenwand-Schichten 217 zu erreichen, wird vorzugsweise ein LPCVD-Verfahren ("low pressure chemical vapour deposition") verwendet. Es ist zu betonen, dass eine thermisch aufgewachsene Siliziumdioxid-Schicht, wie die erste Siliziumdioxid-Seitenwand-Schicht 215 einerseits und eine gemäß dem TEOS-CVD-Verfahren, insbesondere gemäß dem TEOS-LPCVD-Verfahren, aufgebrachte Siliziumdioxid-Schicht (wie die zweite Siliziumdioxid-Seitenwand-Schicht 217) andererseits unterschiedliche physikalische Eigenschaften, insbesondere hinsichtlich der Wechselwirkung mit Ätzchemikalien aufweist.

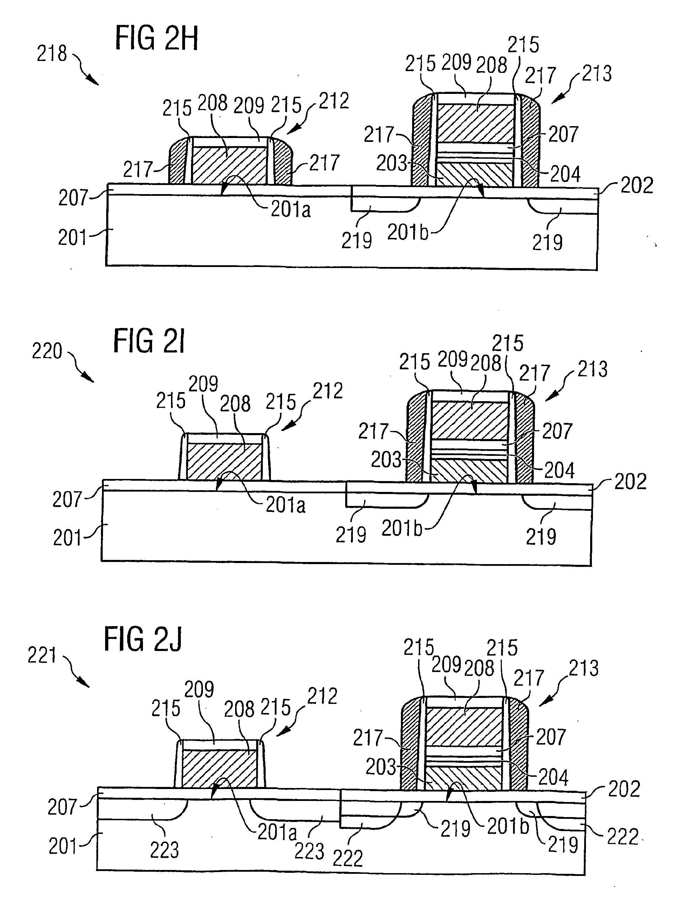

Um auf die in **Fig.2H** gezeigte Schichtstruktur 218 zu gelangen, werden in solche Oberflächen-Bereiche des Silizium-Substrats 201, die an die seitlichen Endabschnitte der zweiten Schichtenfolge 213 angrenzen, Dotieratome eingebracht, wodurch die LDD-Dotier-Bereiche 219 ausgebildet werden.

Dieser Verfahrensschritt wird gemäß dem beschriebenen Ausführungsbeispiel des erfindungsgemäßen Verfahrens zum Herstellen einer Schicht-Anordnung unter Verwendung eines Ionenimplantations-Verfahren realisiert. Darunter wird das Einbringen von Fremdatomen in die Oberfläche eines Festkörpers mittels Beschuss des Festkörpers mit beschleunigten Ionen verstanden. Mittels Ionenimplantation können die elektrischen Eigenschaften des HalbleiterMaterials beeinflusst werden, insbesondere die elektrische Leitfähigkeit erhöht werden. Die Ionen werden mit einer vorgegebenen Energie auf den zweiten Oberflächen-Bereich 201b der Schichtstruktur 216 geschossen und dringen in das Substrat in dessen Grenz-Bereichen zu der zweiten lateral begrenzten Schichtenfolge 213 ein. Dadurch entstehen, wie in Fig.2H gezeigt, LDD-Dotier-Bereiche 219, die gemäß dem beschriebenen Ausführungsbeispiel n-dotiert sind. Diese sind dafür vorgesehen, einen Teil der Source-/Drain-Bereiche des späteren Speicher-Transistors zu bilden. Die Konzentration der Dotieratome in den LDD-Dotier-Bereichen 219 ("lightly doped drain") wird im Weiteren als erste Ladungsträgerdichte bezeichnet.

Um von der in **Fig.2H** gezeigten Schichtstruktur 218 auf die in **Fig.2I** gezeigte Schichtstruktur 220 zu gelangen, wird die zweite Siliziumdioxid-Seitenwand-Schicht 217 von der ersten lateral begrenzten Schichtenfolge 212 entfernt.

Hierzu wird der Teilbereich der Schichtstruktur 218 rechts der gestrichelten Linie, d.h. der Bereich der Speicher-Transistoren, mit einer Maske abgedeckt, wohingegen der Bereich links der gestrichelten Linie, d.h. der Logik-Bereich, mit einem nasschemischen Ätz-Verfahren behandelt wird. Diese Strukturierung ist wiederum unkritisch. Unter Verwendung eines geeigneten nasschemischen Ätz-Verfahrens wird von den ersten lateral begrenzten Schichtenfolgen 212 die zweite Siliziumdioxid-Seitenwand-Schicht 217 entfernt, so dass auf der Seitenwand der ersten lateral begrenzten Schichtenfolgen 212 nur die erste Siliziumdioxid-Seitenwand-Schicht 215 zurückbleibt. Bei dem Nassätz-Verfahren wird die Selektivität des Ätzprozesses ausgenützt. Bezugnehmend auf die Materialkonstellation der Schichtstruktur 218 wird die Tatsache verwendet, dass ein nasschemisches Ätzen der unter Verwendung eines CVD-Verfahrens ausgebildeten zweiten Siliziumdioxid-Seitenwand-Schicht 217 mit Flusssäure (HF) eine wesentlich höhere Ätzrate aufweist, als das nasschemische Ätzen der mittels thermischer Oxidation ausgebildeten ersten Siliziumdioxid-Seitenwand-Schicht 215. Das Verhältnis der Ätzraten von CVD-Siliziumdioxid zu thermisch aufgewachsenem Siliziumdioxid bei nasschemischem Ätzen mit Flusssäure ist ungefähr zehn zu eins. Dadurch ist sichergestellt, dass der Ätz-Prozess ausreichend sicher nach dem Wegätzen der zweiten Siliziumdioxid-Seitenwand-Schicht 217 beendet wird, wohingegen ein unerwünschtes Weiterätzen der ersten Siliziumdioxid-Seitenwand-Schicht 215 in der ersten lateral begrenzten Schichtenfolge 212 weitgehend vermieden ist.

Es sei auf eine Alternative für die Ausgestaltung des erfindungsgemäßen Verfahrens zum Herstellen einer Schicht-Anordnung hingewiesen. In dem oben bezugnehmend auf **Fig.2G** beschriebenen Verfahrensschritt, bei dem die zweiten Siliziumdioxid-Seitenwand-Schichten 217 auf den ersten Siliziumdioxid-Seitenwand-Schichten 215 der ersten und zweiten Schichtenfolgen 212, 214 ausgebildet werden, kann anstelle von Siliziumdioxid (SiO₂) als Material für die zweiten Siliziumdioxid-Seitenwand-Schichten 217 auch Siliziumnitrid (Si₃N₄) verwendet werden. In einem solchen Szenario ist die erste Siliziumdioxid-Seitenwand-Schicht 215 aus thermisch aufgewachsenem Siliziumdioxid hergestellt, wohingegen die zweite Seitenwand-Schicht 217 aus Siliziumnitrid hergestellt ist, das auf die ersten Siliziumdioxid-Seitenwand-Schichten 215 unter Verwendung eines geeigneten CVD-Verfahrens aufgebracht wird. In einem solchen Fall ist anstelle von Flusssäure Phosphorsäure (H₃PO₄) eine geeignete Chemikalie für das nasschemische Ätz-Verfahren, mittels welchem aus der in **Fig.2H** gezeigten Schichtstruktur 218 die in **Fig.2I** gezeigte Schichtstruktur 220 hergestellt wird. In diesem Fall wird die Tatsache verwendet, dass unter Verwendung von Phosphorsäure Siliziumnitrid mit einer wesentlich höheren Ätzrate geätzt wird als Siliziumdioxid. Das Verhältnis der Nassätzraten von unter Verwendung eines CVD-Verfahrens aufgewachsenem Siliziumnitrid und mittels thermischer Oxidation erzeugtem Siliziumdioxid ist größer als zehn zu eins. Daher ist bei Verwendung von Siliziumnitrid als Material für die zweite Seitenwand-Schicht 217 ein ausreichend sicheres Stoppen des Nassätzens der Seitenwand der ersten Schichtenfolge 212 nach dem vollständigen Entfernen der zweiten Seitenwand-Schicht 217 aus Siliziumnitrid sichergestellt.

Um von der in **Fig.2I** gezeigten Schichtstruktur 220 auf die in **Fig.2J** gezeigte Schicht-Anordnung 221 zu gelangen, wird in Oberflächen-Bereiche des Silizium-Wafers 201, die von den seitlichen Endabschnitten der zweiten lateral begrenzten Schichtenfolge 213 räumlich entkoppelt sind, und die mit den LDD-Dotier-Bereichen 219 des Silizium-Wafers 201 teilweise überlappen, Dotierungsatome einer zweiten Ladungsträgerdichte eingebracht, Dadurch werden die HDD-Dotier-Bereiche 222 ("highly doped drain") ausgebildet. Ferner werden in Oberflächen-Bereiche des Silizium-Wafers 201, die an die seitlichen Endabschnitte der ersten lateral begrenzten Schichtenfolge 212 angrenzen, Dotierungsatome einer dritten Ladungsträgerdichte eingebracht, wodurch die dotierten Bereiche 223 ausgebildet werden.

Die beschriebenen Verfahrensschritte, mittels derer die Schicht-Anordnung 221 aus der Schichtstruktur 220 erhalten wird, sind gemäß dem beschriebenen Ausführungsbeispiel des erfindungsgemäßen Herstellungsverfahrens durch Verwendung eines Ionenimplantations-Verfahren realisiert. Es ist darauf hinzuweisen, dass die zweite Ladungsträgerdichte von Dotieratomen in den HDD-Dotier-Bereichen 222 höher ist als die erste Ladungsträgerdichte von Dotieratomen in den ersten LDD-Dotier-Bereichen 219. Das Ausbilden der HDD-Dotier-Bereiche 222 bzw. der dotierten Bereiche 223 kann entweder in einem gemeinsamen Verfahrensschritt oder in zwei voneinander getrennten Verfahrensschritten ausgebildet werden.

Als Produkt des beschriebenen Verfahrens zum Herstellen einer Schicht-Anordnung wird ein bevorzugtes Ausführungsbeispiel der erfindungsgemäßen Schicht-Anordnung 221 mit einem Silizium-Wafer 201, mit einer lateral begrenzten ersten Schichtenfolge 212 auf einem ersten Oberflächen-Bereich 201a des Silizium-Wafers 201, mit einer lateral begrenzten zweiten Schichtenfolge 213 auf einem zweiten Oberflächen-Bereich 201b des Silizium-Wafers 201, mit einer ersten Siliziumdioxid-Seitenwand-Schicht 215 der Dicke d₁ auf den Seitenwänden der ersten und zweiten Schichtenfolgen 212, 213 und mit einer zweiten Silizumdioxid-Seitenwand-Schicht 217 der zweiten Dicke d₂ auf den ersten Siliziumdioxid-Seitenwand-Schichten 215 der zweiten lateral begrenzten Schichtenfolge 213 erhalten.

Zwischen dem Silizium-Wafer 201 und der ersten lateral begrenzten Schichtenfolge 212 ist auf dem ersten Oberflächen-Bereich 201a des Silizium-Wafers 201 die elektrisch isolierende zweite Siliziumdioxid-Schicht 207 angeordnet, und zwischen dem Silizium-Wafer 201 und der zweiten lateral begrenzten Schichtenfolge 213 ist auf dem zweiten Oberflächen-Bereich 201b des Silizium-Wafers 201 eine elektrisch isolierende erste Siliziumdioxid-Schicht 202 angeordnet. Die zweite lateral begrenzte Schichtenfolge 213 weist eine als erste Poly-Silizium-Schicht 203 ausgebildete Ladungsspeicher-Teilschicht, die ONO-Schicht 204, die zweite Siliziumdioxid-Schicht 207, die zweite Poly-Silizium-Schicht 208 und die Siliziumnitrid-Hartmaske 209 auf. Die erste lateral begrenzte Schichtenfolge 212 weist die zweite Poly-Silizium-Schicht 208 und die Siliziumnitrid-Hartmaske 209 auf.

Der linke Bereich von **Fig.2J** kann als Logik-Transistor eines Logik-Bereichs eines integrierten Schaltkreises verwendet werden, wohingegen der rechte Bereich der Schicht-Anordnung 221 aus **Fig.2J** als Speicher-Transistor eines Speicher-Bereichs eines integrierten Schaltkreises verwendet werden kann. Die erste lateral begrenzte Schichtenfolge 212 bildet gemeinsam mit den dotierten Bereichen 223 einen Logik-Transistor, der eine als erste Siliziumdioxid-Seitenwand-Schicht 215 ausgebildete Seitenwand-Schicht einer ausreichend geringen Dicke d₁ aufweist, dass der Logik-Transistor ausreichend schnell ist und einen ausreichend niederohmigen Anschlusswiderstand aufweist. Dabei fungieren die dotierten Bereiche 223 als erster bzw. zweiter Source-/Drain-Bereich, die zweite Siliziumdioxid-Schicht 207 als Gateoxid-Schicht und die zweite Poly-Silizium-Schicht 208 als Gate-Elektrode.

Dagegen weist der Speicher-Transistor in dem rechten Bereich der Schicht-Anordnung 221 aus **Fig.2J****,** der von der zweiten lateral begrenzten Schichtenfolge 213 sowie den LDD-Dotier-Bereichen 219 und den HDD-Dotier-Bereichen 222 gebildet ist, eine aus der ersten Siliziumdioxid-Seitenwand-Schicht 215 und der zweiten Siliziumdioxid-Seitenwand-Schicht 217 gebildete ausreichend dicke Seitenwand-Schicht der ungefähren Dicke d₁+d₂ auf und ist so von der Umgebung ausreichend sicher abgeschirmt. Bei dem als Speicher-Transistor ausgebildeten rechten Bereich der Schicht-Anordnung 221 fungieren die LDD-Dotier-Bereiche 219 und die HDD-Dotier-Bereiche 222 als erster bzw. als zweiter Source-/Drain-Bereich, die erste Siliziumdioxid-Schicht 202 fungiert als Gateoxid-Schicht, die erste Poly-Silizium-Schicht 203 fungiert als Ladungsspeicher-Schicht, in welche beispielsweise mittels Fowler-Nordheim-Tunnelns oder heißer Elektronen elektrische Ladungsträger dauerhaft injizierbar sind, die ONO-Schicht 204 und die zweite Siliziumdioxid-Schicht 207 fungieren als elektrische Isolationsschicht zwischen der Ladungsspeicher-Schicht 203 und der zweiten Poly-Silizium-Schicht 208, wobei die Anordnung aus den Schichten 204, 207 ausreichend dick ist, um eine ausreichend lange Haltezeit der in der ersten Poly-Silizium-Schicht 203 gespeicherten Information sicherzustellen, die zweite Poly-Silizium-Schicht 208 fungiert als Gate-Elektrode und die Siliziumnitrid-Hartmaske 209 fungiert als Schutzschicht.

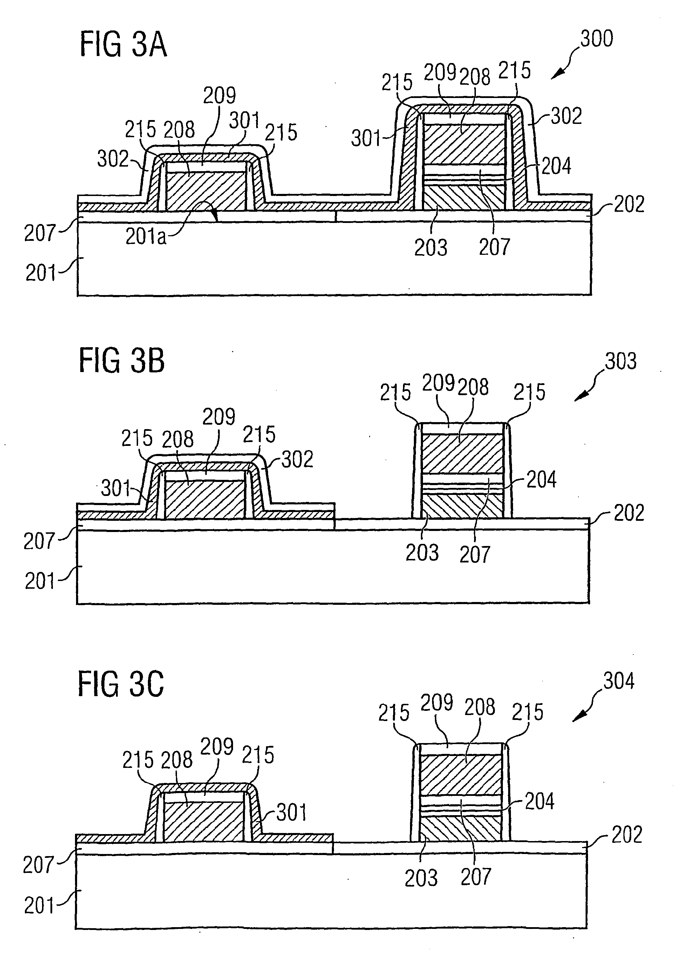

Im Weiteren wird bezugnehmend auf **Fig.3A** bis **Fig.3E** ein anderes bevorzugtes Ausführungsbeispiel des erfindungsgemäßen Verfahrens zum Herstellen einer Schicht-Anordnung beschrieben.

Die bezugnehmend auf **Fig.2A** bis **Fig.2F** beschriebenen Verfahrensschritte sind gemäß dem im Weiteren beschriebenen Ausführungsbeispiel identisch wie bei dem Verfahren, das bezugnehmend auf **Fig.2A** bis **Fig.2J** beschrieben ist.

Die Schichtstruktur 300, die in **Fig.3A** gezeigt ist, wird erhalten, indem ausgehend von der in **Fig.2F** gezeigten Schichtstruktur 214 auf den lateral begrenzten Schichtenfolgen des Logik-Bereichs (links in der Figur) und des Speicher-Bereichs (rechts in der Figur) eine erste Hilfs-Schicht 301 aus Siliziumnitrid ganzflächig abgeschieden wird. Anschließend wird auf der ersten Siliziumnitrid-Hilfs-Schicht 301 z.B. eine zweite Siliziumdioxid-Hilfs-Schicht 302 abgeschieden.

Um die in **Fig.3B** gezeigte Schichtstruktur 303 zu erhalten, wird der gemäß **Fig.3B** linke Oberflächen-Bereich des Substrats 201 unter Verwendung einer geeigneten Maske lithographisch abgedeckt, und es wird die zweite Siliziumdioxid-Hilfs-Schicht 302 und die erste Siliziumnitrid-Hilfs-Schicht 301 von der gemäß **Fig.3B** rechten lateral begrenzten Schichtenfolge entfernt. Das Entfernen der zweiten Siliziumdioxid-Hilfs-Schicht 302 erfolgt unter Verwendung eines nasschemischen Ätz-Verfahrens. Anschließend wird der Photoresist von der Oberfläche der Schichtstruktur entfernt, und es wird die erste Siliziumnitrid-Hilfs-Schicht 301 unter Verwendung eines nasschemischen Ätz-Verfahrens mit heißer Phosphorsäure entfernt. Der gemäß **Fig.3B** linke Teilbereich der Schichtstruktur ist hierbei jedoch vor einem Entfernen der ersten Siliziumnitrid-Hilfs-Schicht 301 geschützt. Dies beruht auf der hohen Selektivität beim Ätzen mit heißer Phosphorsäure, d.h., dass mit dieser Chemikalie Siliziumnitrid effektiv geätzt werden kann, wohingegen Siliziumdioxid vor einem Ätzen geschützt ist.

Um die in **Fig.3C** gezeigte Schichtstruktur 304 zu erhalten, wird die zweite Siliziumdioxid-Hilfs-Schicht 302 von dem gemäß **Fig.3C** linken Oberflächen-Bereich des Silizium-Substrats 201 entfernt. Dies erfolgt unter Verwendung eines Ätz-Verfahrens mit verdünnter Flusssäure, wobei die hohe Selektivität beim Ätzen mit Flusssäure von einerseits mittels thermischen Oxidierens hergestelltem Siliziumdioxid und von andererseits z.B. unter Verwendung eines ozonaktivierten Abscheideverfahrens hergestelltem Siliziumdioxid vorteilhaft verwendet wird. Mit anderen Worten ist es mit verdünnter Flusssäure mit einer hohen Ätzrate möglich, Siliziumdioxid, das unter Verwendung eines z.B. ozonaktivierten Abscheideverfahrens aufgebracht worden ist und das noch nicht durch einen Hochtemperaturprozeß verdichtet wurde, zu entfernen. Dagegen erfolgt ein Entfernen von mittels thermischen Oxidierens hergestelltem Siliziumdioxid unter Verwendung verdünnter Flusssäure mit weitaus geringerer Ätzrate.

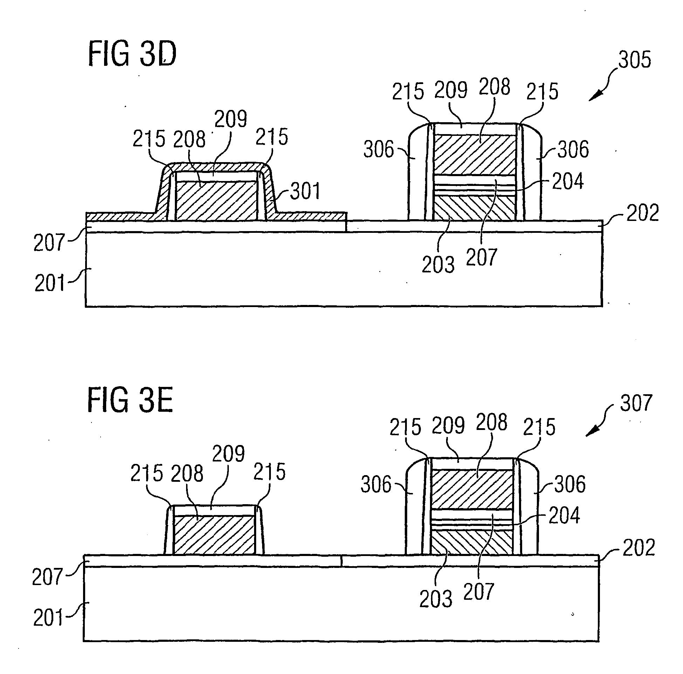

Um die in **Fig.3D** gezeigte Schichtstruktur 305 zu erhalten, wird mittels thermischen Oxidierens eine zweite Siliziumdioxid-Seitenwand-Schicht 306 auf der gemäß **Fig.3D** rechten lateral begrenzten Schichtenfolge ausgebildet. Es ist anzumerken, dass die gemäß **Fig.3D** linke lateral begrenzte Schichtenfolge vor einem thermischen Oxidieren geschützt ist, da die erste Siliziumnitrid-Hilfs-Schicht 301 als Oxidationsbarriere wirkt. Anschaulich dient die erste Siliziumnitrid-Hilfs-Schicht 301 infolge der gewählten Material-Konfiguration (thermisch oxidiertes Siliziumdioxid/Siliziumnitrid) als Schutzschicht zum Schützen vor dem Ausbilden eines thermisch oxidierten Siliziumdioxid-Bereichs.

Um die in **Fig.3E** gezeigte Schichtstruktur 307 zu erhalten, wird unter Verwendung eines geeigneten nasschemischen Ätz-Verfahrens die erste Siliziumnitrid-Hilfs-Schicht 301 von der gemäß **Fig.3E** linken lateral begrenzten Schichtenfolge entfernt. Aufgrund der hohen Ätz-Selektivität (wiederum in z.B. heißer Phosphorsäure) wird hingegen die zweite Siliziumdioxid-Seitenwandschicht 306 und die erste Siliziumdioxid-Seitenwand-Schicht 215 der gemäß **Fig.3E** rechten und linken lateral begrenzten Schichtenfolge von dem Ätzmittel nicht angegriffen.

Dadurch wird die in **Fig.3E** gezeigte Schichtstruktur 307 erhalten. Die gemäß **Fig.3E** linke lateral begrenzte Schichtenfolge ist mit einer dünnen Seitenwandoxid-Schicht versehen (lediglich die erste Siliziumdioxid-Seitenwand-Schicht 215), wohingegen die gemäß **Fig.3E** rechte lateral begrenzte Schichtenfolge mit einer dicken Seitenwandoxid-Schicht bedeckt ist (gebildet von der ersten Siliziumdioxid-Seitenwand-Schicht 215 und der zweiten Siliziumdioxid-Seitenwand-Schicht 306).

Es ist anzumerken, dass - insbesondere bei einer Verwendung der Schichtstruktur 307 als Anordnung von Feldeffekttransistoren - an die lateral begrenzten Schichtenfolgen angrenzende dotierte Oberflächen-Bereiche des Substrats 201 erforderlich sein können. Solche dotierten Bereiche können an geeigneter Stelle während des Herstellungsverfahrens beispielsweise unter Verwendung eines Ionenimplantations-Verfahrens ausgebildet werden.

In diesem Dokument ist folgende Veröffentlichung zitiert:
[1] Widmann, D, Mader, H, Friedrich, H (1996) "Technologie hochintegrierter Schaltungen", Kapitel 8.4, Springer Verlag, Berlin, IBSN 3-540-59357-8
[2] US 5,291,052
[3] US 6,160,317
[4] DE 196 54 738 A1
[5] GB 2,359,662

### Bezugszeichenliste

- 100: Schichtstruktur
- 101: Silizium-Substrat
- 102: erste Siliziumdioxid-Schicht
- 103: erste Poly-Silizium-Schicht
- 104: ONO-Schichtenfolge
- 105: Schichtstruktur
- 106: Schichtstruktur
- 107: zweite Siliziumdioxid-Schicht
- 108: zweite Poly-Silizium-Schicht
- 109: Siliziumnitrid-Hartmaske
- 110: Schichtstruktur
- 111: Schichtstruktur
- 112: erste Seitenwandoxid-Schicht
- 113: Schichtstruktur
- 114a: erster LDD-Bereich
- 114b: zweiter LDD-Bereich
- 115: Schichtstruktur
- 116: Schichtstruktur
- 117: zweite Seitenwandoxid-Schicht
- 118: Schichtstruktur
- 119a: erster dotierter Bereich
- 119b: zweiter dotierter Bereich
- 120a: erster HDD-Bereich
- 120b: zweiter HDD-Bereich
- 200: Schichtstruktur
- 201: Silizium-Wafer
- 201a: erster Oberflächen-Bereich
- 201b: zweiter Oberflächen-Bereich
- 202: erste Siliziumdioxid-Schicht
- 203: erste Poly-Silizium-Schicht
- 204: ONO-Schicht
- 204a: Siliziumdioxid-Teilschicht
- 204b: Siliziumnitrid-Teilschicht
- 204c: weitere Siliziumdioxid-Teilschicht
- 205: Schichtstruktur
- 206: Schichtstruktur
- 207: zweite Siliziumdioxid-Schicht
- 208: zweite Poly-Silizium-Schicht
- 209: Hartmaske
- 210: Schichtstruktur
- 211: Schichtstruktur
- 212: erste lateral begrenzte Schichtenfolge
- 213: zweite lateral begrenzte Schichtenfolge
- 213a: lateral begrenzte Hilfs-Schichtenfolge
- 214: Schichtstruktur
- 215: erste Siliziumdioxid-Seitenwand-Schicht
- 216: Schichtstruktur
- 217: zweite Siliziumdioxid-Seitenwand-Schicht
- 218: Schichtstruktur
- 219: LDD-Dotier-Bereiche
- 220: Schichtstruktur
- 221: Schicht-Anordnung
- 222: HDD-Dotier-Bereiche
- 223: dotierte Bereiche
- 300: Schichtstruktur
- 301: erste Siliziumnitrid-Hilfs-Schicht
- 302: zweite Siliziumdioxid-Hilfs-Schicht
- 303: Schichtstruktur
- 304: Schichtstruktur
- 305: Schichtstruktur
- 306: zweite Siliziumdioxid-Seitenwand-Schicht
- 307: Schichtstruktur

## Patentansprüche

1. Verfahren zum Herstellen einer Schicht-Anordnung, bei dem
A mindestens eine jeweils lateral begrenzte erste Schichtenfolge mit zumindest einer Polysiliziumschicht, zumindest als Teil eines Logik-Bereichs einer Speicher-Anordnung, auf einem ersten Oberflächen-Bereich eines Substrats und mindestens eine jeweils lateral begrenzte zweite Schichtenfolge mit zumindest einer Polysiliziumschicht, zumindest als Teil eines Speicherzellen-Bereichs der Speicher-Anordnung, auf einem zweiten Oberflächen-Bereich des Substrats ausgebildet wird;
B jeweils eine erste Seitenwand-Schicht einer ersten Dicke aus einem ersten elektrisch isolierenden Material auf zumindest einem Teil-Bereich der Seitenwände der ersten und zweiten Schichtenfolge mittels thermischen Oxidierens ausgebildet wird;
C jeweils eine zweite Seitenwand-Schicht einer zweiten Dicke aus einem zweiten elektrisch isolierenden Material auf zumindest einem Teil-Bereich der ersten Seitenwand-Schichten der ersten und zweiten Schichtenfolge ausgebildet wird;
D die zweiten Seitenwand-Schichten von den ersten Schichtenfolgen vollständig entfernt werden.

2. Verfahren nach Anspruch 1,
bei dem in Teilschritten von Schritt A
A1 eine erste elektrisch isolierende Hilfsschicht auf dem ersten und dem zweiten Oberflächen-Bereich des Substrats, eine zweite elektrisch leitfähige Hilfsschicht auf der ersten elektrisch isolierenden Hilfsschicht und eine dritte elektrisch isolierende Hilfsschicht auf der zweiten elektrisch leitfähigen Hilfsschicht ausgebildet werden;
A2 die erste, zweite und dritte Hilfsschicht von dem ersten Oberflächen-Bereich des Substrats entfernt wird;
A3 eine vierte elektrisch isolierende Hilfsschicht auf dem ersten und dem zweiten Oberflächen-Bereich des Substrats, eine fünfte elektrisch leitfähige Hilfsschicht auf der vierten elektrisch isolierenden Hilfsschicht und eine sechste elektrisch isolierende Hilfsschicht auf der fünften elektrisch leitfähigen Hilfsschicht ausgebildet werden;
A4 die fünfte und die sechste Hilfsschicht auf dem ersten und dem zweiten Oberflächen-Bereich gemeinsam derart strukturiert werden, dass auf dem ersten Oberflächen-Bereich die mindestens eine lateral begrenzte erste Schichtenfolge gebildet wird;
A5 auf dem zweiten Oberflächen-Bereich die zweite, die dritte und die vierte Hilfsschicht derart strukturiert werden, dass **dadurch** die mindestens eine jeweils lateral begrenzte zweite Schichtenfolge auf dem zweiten Oberflächen-Bereich gebildet wird.

3. Verfahren nach Anspruch 1 oder 2,
bei dem nach Schritt C und vor Schritt D in Oberflächen-Bereiche des Substrats, die an die seitlichen End-Abschnitte der zweiten Schichtenfolgen angrenzen, Dotierungsatome eingebracht werden.

4. Verfahren nach Anspruch 3,
bei dem nach Schritt D in Oberflächen-Bereiche des Substrats, die von den seitlichen End-Abschnitten der zweiten Schichtenfolgen räumlich entkoppelt sind, und die mit denjenigen Oberflächen-Bereichen des Substrats teilweise überlappen, in die Dotierungsatome eingebracht worden sind, Dotierungsatome eingebracht werden.

5. Verfahren nach einem der Ansprüche 1 bis 4,
bei dem nach Schritt D in Oberflächen-Bereiche des Substrats, die an die seitlichen End-Abschnitte der ersten Schichtenfolgen angrenzen, Dotierungsatome eingebracht werden.

6. Verfahren zum Herstellen einer Schicht-Anordnung, bei dem
A mindestens eine jeweils lateral begrenzte erste Schichtenfolge auf einem ersten Oberflächen-Bereich eines Substrats und mindestens eine jeweils lateral begrenzte zweite Schichtenfolge auf einem zweiten Oberflächen-Bereich des Substrats ausgebildet wird;
B jeweils eine erste Seitenwand-Schicht einer ersten Dicke aus einem ersten elektrisch isolierenden Material auf zumindest einem Teil-Bereich der Seitenwände der ersten und zweiten Schichtenfolge ausgebildet wird;
C eine Hilfs-Seitenwand-Schicht auf zumindest einem Teil-Bereich der ersten Seitenwand-Schichten der ersten Schichtenfolge ausgebildet wird;
D eine zweite Seitenwand-Schicht einer zweiten Dicke aus einem zweiten elektrisch isolierenden Material auf zumindest einem Teil-Bereich der ersten Seitenwand-Schicht der zweiten Schichtenfolge ausgebildet wird, wobei das Material der Hilfs-Seitenwand-Schicht derart gewählt wird, dass während des Ausbildens der zweiten Seitenwand-Schicht auf zumindest einem Teil-Bereich der ersten Seitenwand-Schicht der zweiten Schichtenfolge die Hilfs-Seitenwand-Schicht von einer Bedeckung mit dem zweiten elektrisch isolierenden Material frei bleibt.

7. Verfahren nach Anspruch 6,
bei dem nach Schritt D die Hilfs-Seitenwand-Schicht von dem ersten Schichtenstapel entfernt wird.

8. Verfahren nach Anspruch 6 oder 7,
bei dem die zweite Seitenwand-Schicht mittels thermischen Oxidierens zumindest eines Teils des Materials der zweiten lateral begrenzten Schichtenfolge ausgebildet wird.

9. Verfahren nach einem der Ansprüche 6 bis 8,
bei dem das erste und das zweite elektrisch isolierende Material Siliziumdioxid und bei dem das Material der Hilfs-Seitenwand-Schicht Siliziumnitrid ist.

10. Schicht-Anordnung
• mit einem Substrat;
• mit mindestens einer jeweils lateral begrenzten ersten Schichtenfolge mit zumindest einer Polysiliziumschicht, zumindest als Teil eines Logik-Bereichs einer Speicher-Anordnung, auf einem ersten Oberflächen-Bereich des Substrats;
• mit mindestens einer jeweils lateral begrenzten zweiten Schichtenfolge mit zumindest einer Polysiliziumschicht, zumindest als Teil eines Speicherzellen-Bereichs der Speicher-Anordnung, auf einem zweiten Oberflächen-Bereich des Substrats;
• mit jeweils einer ersten Seitenwand-Schicht einer ersten Dicke aus einem ersten elektrisch isolierenden Material auf zumindest einem Teil-Bereich jeder der Seitenwände jeder der ersten und zweiten Schichtenfolgen, wobei die erste Seitenwand-Schicht mittels thermischen Oxidierens gebildet ist;
• mit jeweils einer zweiten Seitenwand-Schicht einer zweiten Dicke aus einem zweiten elektrisch isolierenden Material auf zumindest einem Teil-Bereich jeder der ersten Seitenwand-Schichten jeder der zweiten Schichtenfolgen, wobei die ersten Seitenwand-Schichten jeder der ersten Schichtenfolgen von den zweiten Seitenwand-Schichten frei sind.

11. Schicht-Anordnung nach Anspruch 10,
bei der die erste Dicke kleiner als die zweite Dicke ist.

12. Schicht-Anordnung nach Anspruch 10 oder 11,
bei der erste Dicke zwischen ungefähr 5nm und 7nm ist.

13. Schicht-Anordnung nach einem der Ansprüche 10 bis 12,
bei der zweite Dicke ungefähr 10nm oder größer ist.

14. Schicht-Anordnung nach einem der Ansprüche 10 bis 13,
bei der das Substrat ein
• Silizium-Wafer; oder
• ein Silizium-Chip
ist.

15. Schicht-Anordnung nach einem der Ansprüche 10 bis 14,
bei der zwischen dem Substrat und zumindest einem Teil der ersten und/oder der zweiten Schichtenfolgen auf zumindest einem Teil der Oberfläche des Substrats eine Isolationsschicht aus einem dritten elektrisch isolierenden Material angeordnet ist.

16. Schicht-Anordnung nach einem der Ansprüche 10 bis 15,
bei der die erste Schichtenfolge eine erste Teilschicht aus Polysilizium und eine zweite Teilschicht aus einem vierten elektrisch isolierenden Material aufweist.

17. Schicht-Anordnung nach einem der Ansprüche 10 bis 16,
bei der die zweite Schichtenfolge eine Ladungsspeicher-Teilschicht, eine zweite Teilschicht aus einem fünften elektrisch isolierenden Material, eine dritte Teilschicht aus Polysilizium und eine vierte Teilschicht aus einem sechsten elektrisch isolierenden Material aufweist.

18. Schicht-Anordnung nach Anspruch 17,
bei der die Ladungsspeicher-Teilschicht
• eine Schicht aus polykristallinem Silizium mit einer Siliziumdioxid-Siliziumnitrid-Siliziumdioxid-Schichtenfolge (ONO-Schicht) als Deckschicht ist; oder
• eine Siliziumdioxid-Siliziumnitrid-Siliziumdioxid-Schichtenfolge (ONO-Schicht)
ist.

19. Schicht-Anordnung nach Anspruch 17 oder 18,
bei der das erste und/oder das zweite elektrisch leitfähige Material polykristallines Silizium ist.

20. Schicht-Anordnung nach einem der Ansprüche 17 bis 19, bei der voneinander unabhängig das erste, zweite, dritte, vierte, fünfte und sechste elektrisch isolierende Material
• Siliziumdioxid;
• Siliziumnitrid; oder
• eine Siliziumdioxid-Siliziumnitrid-Siliziumdioxid-Schichtenfolge (ONO-Schicht)
ist.

21. Speicher-Anordnung mit
einer Schicht-Anordnung nach einem der Ansprüche 6 bis 16, bei der
• die mindestens eine erste Schichtenfolge auf dem ersten Oberflächen-Bereich des Substrats mindestens einen Teil des Logik-Bereichs der Speicher-Anordnung bildet;
• die mindestens eine zweite Schichtenfolge auf dem zweiten Oberflächen-Bereich des Substrats mindestens einen Teil des Speicherzellen-Bereichs der Speicher-Anordnung bildet.

## Claims

1. Method for fabricating a layer arrangement, wherein
A at least a respectively laterally delimited first layer sequence with at least one polysilicon layer is formed, at least as part of a logic region of a memory arrangement, on a first surface region of a substrate and at least a respectively laterally delimited second layer sequence with at least one polysilicon layer is formed, at least as part of a memory cell region of the memory arrangement, on a second surface region of the substrate;
B respectively a first side wall layer of a first thickness is formed of a first electrically insulating material on at least one sub-region of the side walls of the first and second layer sequences by means of thermal oxidation;
C respectively a second side wall layer of a second thickness is formed of a second electrically insulating material on at least one sub-region of the first side wall layers of the first and second layer sequences;
D the second side wall layers are removed completely from the first layer sequences.

2. Method according to claim 1,
wherein in sub-steps of step A
A1 a first electrically insulating auxiliary layer is formed on the first and the second surface regions of the substrate, a second electrically conductive auxiliary layer is formed on the first electrically insulating auxiliary layer and a third electrically insulating auxiliary layer is formed on the second electrically conductive auxiliary layer;
A2 the first, second and third auxiliary layers are removed from the first surface region of the substrate;
A3 a fourth electrically insulating auxiliary layer is formed on the first and the second surface regions of the substrate, a fifth electrically conductive auxiliary layer is formed on the fourth electrically insulating auxiliary layer and a sixth electrically insulating auxiliary layer is formed on the fifth electrically conductive auxiliary layer;
A4 the fifth and the sixth auxiliary layers are jointly patterned on the first and the second surface regions in such a manner that the at least one laterally delimited first layer sequence is formed on the first surface region;
A5 the second, the third and the fourth auxiliary layers are patterned on the second surface region in such a manner that thereby the at least one laterally delimited second layer sequence is formed on the second surface region.

3. Method according to claim 1 or 2,
wherein after step C and before step D doping atoms are introduced into surface regions of the substrate which adjoin the lateral end sections of the second layer sequences.

4. Method according to claim 3,
wherein after step D doping atoms are introduced into surface regions of the substrate which are spatially decoupled from the lateral end sections of the second layer sequences and which partially overlap with those surface regions of the substrate, into which doping atoms have been introduced.

5. Method according to any of claims 1 to 4,
wherein after step D doping atoms are introduced into surface regions of the substrate which adjoin the lateral end sections of the first layer sequences.

6. Method for fabricating a layer arrangement, wherein
A at least a respectively laterally delimited first layer sequence is formed on a first surface region of a substrate and at least a respectively laterally delimited second layer sequence is formed on a second surface region of the substrate;
B respectively a first side wall layer of a first thickness is formed of a first electrically insulating material on at least one sub-region of the side walls of the first and second layer sequences;
C an auxiliary side wall layer is formed on at least a sub-region of the first side wall layers of the first layer sequence;
D a second side wall layer of a second thickness is formed of a second electrically insulating material on at least a sub-region of the first side wall layer of the second layer sequence, wherein the material of the auxiliary side wall layer is selected such that, while forming the second side wall layer on at least a sub-region of the first side wall layer of the second layer sequence, the auxiliary side wall layer remains free from the second electrically insulating material.

7. Method according to claim 6,
wherein after step D the auxiliary side wall layer is removed from the first layer stack.

8. Method according to claim 6 or 7,
wherein the second side wall layer is formed by means of thermal oxidation of at least a part of the material of the second laterally delimited layer sequence.

9. Method according to any of claims 6 to 8,
wherein the first and the second electrical insulating materials are silicon dioxide, and in which the material of the auxiliary side wall layer is silicon nitride.

10. Layer arrangement,
• with a substrate;
• with at least one respectively laterally delimited first layer sequence with at least one polysilicon layer, at least as part of a logic region of a memory arrangement, on a first surface region of the substrate.
• with at least one respectively laterally delimited second layer sequence with at least one polysilicon layer, at least as part of a memory cell region of the memory arrangement, on a second surface region of the substrate;
• with respectively a first side wall layer of a first thickness of a first electrically insulating material on at least one sub-region of each of the side walls of each of the first and second layer sequences, wherein the first side wall layer is formed by means of thermal oxidation;
• with respectively a second side wall layer of a second thickness of a second electrically insulating material on at least a sub-region of each of the first side wall layers of each of the second layer sequences, wherein the first side wall layers of each of the first layer sequences are free from the second side wall layers.

11. Layer arrangement according to claim 10,
wherein the first thickness is less than the second thickness.

12. Layer arrangement according to claim 10 or 11,
wherein the first thickness is between approximately 5 nm and 7 nm.

13. Layer arrangement according to any of claims 10 to 12,
wherein the second thickness is approximately 10 nm or above.

14. Layer arrangement according to any of claims 10 to 13,
wherein the substrate is a
• silicon wafer; or
• a silicon chip.

15. Layer arrangement according to any of claims 10 to 14,
wherein an insulation layer of a third electrically insulating material is arranged between the substrate and at least a part of the first and/or second layer sequences on at least a part of the surface of the substrate.

16. Layer arrangement according to any of claims 10 to 15,
wherein the first layer sequence comprises a first part-layer of polysilicon and a second part-layer of a fourth electrically insulating material.

17. Layer arrangement according to any of claims 10 to 16,
wherein the second layer sequence comprises a charge-storage part-layer, a second part-layer of a fifth electrically insulating material, a third part-layer of polysilicon and a fourth part-layer of a sixth electrically insulating material.

18. Layer arrangement according to claim 17,
wherein the charge-storing part-layer is
• a layer of polycrystalline silicon with a silicon dioxide-silicon nitride-silicon dioxide layer sequence (ONO layer) as covering layer; or
• a silicon dioxide-silicon nitride-silicon dioxide layer sequence (ONO layer).

19. Layer arrangement according to claim 17 or 18,
wherein the first and/or second electrically conductive material is polycrystalline silicon.

20. Layer arrangement according to any of claims 17 to 19,
wherein the first, second, third, fourth, fifth and sixth materials are independent from each other:
• silicon dioxide;
• silicon nitride; or
• a silicon dioxide-silicon nitride-silicon dioxide layer sequence (ONO layer).

21. Memory arrangement with a layer arrangement according to any of claims 6 to 16, wherein
• the at least one first layer sequence on the first surface region of the substrate forms at least a part of the logic region of the memory arrangement;
• the at least second layer sequence on the second surface region of the substrate forms at least a part of the memory cell region of the memory arrangement.

## Revendications

1. Procédé de production d'un agencement stratifié, dans lequel
A on forme au moins une première succession de couches, respectivement limitées latéralement et ayant une couche en polysilicium, au moins en tant que partie d'une zone logique d'un dispositif de mémoire, sur une première zone de surface de substrat et au moins une deuxième succession de couches, respectivement limitées latéralement, et ayant au moins une couche de polysilicium, au moins en tant que partie d'une zone de cellule de mémoire du dispositif de mémoire, sur une deuxième zone de surface du substrat ;
B on forme respectivement une première couche de paroi latérale d'une première épaisseur en un premier matériau isolant du point de vue électrique sur au moins une zone partielle des parois latérales des première et deuxième successions de couches au moyen d'une oxydation thermique ;
C on forme respectivement une deuxième couche de paroi latérale d'une deuxième épaisseur en un deuxième matériau isolant du point de vue électrique sur au moins une zone partielle des premières couches de paroi latérale des première et deuxième successions de couches ;
D on élimine complètement les deuxièmes couches de paroi latérale des premières successions de couches.

2. Procédé suivant la revendication 1,
dans lequel dans les sous-stades du stade A
A1 on forme une première couche auxiliaire isolante électrique sur la première et sur la deuxième zones de surface du substrat, une deuxième couche auxiliaire conductrice de l'électricité sur la première couche auxiliaire isolante du point de vue électrique et une troisième couche auxiliaire isolante du point de vue électrique sur la deuxième couche auxiliaire conductrice de l'électricité ;
A2 on élimine la première, deuxième et troisième couches auxiliaires de la première zone de surface de substrat ;
A3 on forme une quatrième couche auxiliaire isolante du point de vue électrique sur la première et la deuxième zones de surface du substrat, une cinquième couche auxiliaire conductrice de l'électricité sur la quatrième couche auxiliaire isolante du point de vue électrique et une sixième couche auxiliaire isolante du point de vue électrique sur la cinquième couche auxiliaire conductrice de l'électricité ;
A4 on structure conjointement la cinquième et la sixième couches auxiliaires sur la première zone de surface et sur la deuxième zone de surface de manière à former la au moins une première succession de couches limitée latéralement sur la première zone de surface ;
A5 on structure la deuxième, la troisième et la quatrième couches auxiliaires sur la deuxième zone de surface de manière à former ainsi la au moins une deuxième succession de couches respectivement limitées latéralement sur la deuxième zone de surface.

3. Procédé suivant la revendication 1 ou 2,
dans lequel, après le stade C et avant le stade D, on introduit des atomes de dopage dans des zones de surface du substrat, qui sont voisines des sections d'extrémité latérales des deux successions de couches.

4. Procédé suivant la revendication 3,
dans lequel, après le stade D, on introduit des atomes de dopage dans des zones de surface du substrat, qui sont découplées spatialement des sections d'extrémité latérales des deuxièmes successions de couches et qui chevauchent en partie les zones de surface du substrat, dans lesquelles des atomes de dopage ont été introduits.

5. Procédé suivant l'une des revendications 1 à 4,
dans lequel, après le stade D, on introduit des atomes de dopage dans des zones de surface du substrat, qui sont voisines des sections d'extrémité latérales des premières successions de couches.

6. Procédé de production d'un agencement stratifié, dans lequel
A on forme au moins une première succession de couches respectivement limitées latéralement sur une première zone de surface du substrat et au moins une deuxième succession de couches respectivement limitées latéralement sur une deuxième zone de surface du substrat ;
B on forme respectivement une première couche de paroi latérale d'une première épaisseur en un premier matériau isolant du point de vue électrique sur au moins une zone partielle des parois latérales de la première et de la deuxième succession de couches ;
C on forme une couche auxiliaire de paroi latérale sur au moins une zone partielle des premières couches des parois latérales de la première succession de couches ;
D on forme une deuxième couche de paroi latérale d'une deuxième épaisseur en un deuxième matériau isolant du point de vue électrique sur au moins une zone partielle de la première couche de paroi latérale de la deuxième succession de couches, le matériau de la couche auxiliaire de paroi latérale étant choisi de manière à ce que,avant la formation de la deuxième couche de paroi latérale sur au moins une zone partielle de la première couche de paroi latérale de la deuxième succession de couches, la couche auxiliaire de paroi latérale reste exempte d'un revêtement par le deuxième matériau isolant du point de vue électrique.

7. Procédé suivant la revendication 6,
dans lequel, après le stade D, on élimine la couche auxiliaire de paroi latérale de la première pile de couches.

8. Procédé suivant la revendication 6 ou 7,
dans lequel on forme la deuxième couche de paroi latérale au moyen d'une oxydation thermique d'au moins une partie du matériau de la deuxième succession de couches limitées latéralement.

9. Procédé suivant l'une des revendications 6 à 8,
dans lequel le premier et le deuxième matériaux isolants du point de vue électrique est du dioxyde de silicium et dans lequel le matériau de la couche auxiliaire de paroi latérale est du nitrure de silicium.

10. Agencement stratifié
• comprenant un substrat ;
• comprenant au moins une première succession de couches respectivement limitées latéralement et ayant au moins une couche de polysilicium, au moins en tant que partie d'une zone logique d'un dispositif de mémoire, sur une première zone de surface du substrat ;
• comprenant au moins une deuxième succession de couches respectivement limitées latéralement et ayant au moins une couche de polysilicium, au moins en tant que partie d'une zone de cellule de mémoire du dispositif de mémoire, sur une deuxième zone de surface du substrat ;
• comprenant respectivement une première couche de paroi latérale d'une première épaisseur en un premier matériau isolant du point de vue électrique sur au moins une zone partielle de chacune des parois latérales de chacune des première et deuxième successions de couches, la première couche de paroi latérale étant formée au moyen d'une oxydation thermique ;
• comprenant respectivement une deuxième couche de paroi latérale d'une deuxième épaisseur en un deuxième matériau isolant du point de vue électrique sur au moins une zone partielle de chacune des premières couches de paroi latérale de chacune des deuxièmes successions de couches, les premières couches de paroi latérale de chacune des premières successions de couches étant exemptes des deuxièmes couches de paroi latérale.

11. Dispositif stratifié suivant la revendication 10,
dans lequel la première épaisseur est plus petite que la deuxième épaisseur.

12. Dispositif stratifié suivant la revendication 10 ou 11,
dans lequel la première épaisseur est comprise entre environ 5 nm et 7 nm.

13. Dispositif stratifié suivant l'une des revendications 10 à 12,
dans lequel la deuxième épaisseur est d'environ 10 nm ou plus grande.

14. Dispositif stratifié suivant l'une des revendications 10 à 13,
dans lequel le substrat est
• une tranche de silicium ; ou
• une puce de silicium.

15. Dispositif stratifié suivant l'une des revendications 10 à 14,
dans lequel il est disposé entre le substrat et au moins une partie des première et/ou des deuxièmes successions de couches une couche isolante en un troisième matériau isolant du point de vue électrique sur au moins une partie de la surface du substrat.

16. Dispositif stratifié suivant l'une des revendications 10 à 15,
dans lequel la première succession de couches a une première couche partielle en polysilicium et une deuxième couche partielle en un quatrième matériau isolant du point de vue électrique.

17. Dispositif stratifié suivant l'une des revendications 10 à 16,
dans lequel la deuxième succession de couches comporte une couche partielle d'accumulation de charges et une deuxième couche partielle en un cinquième matériau isolant du point de vue électrique, une troisième couche partielle en polysilicium et une quatrième couche partielle en un sixième matériau isolant du point de vue électrique.

18. Dispositif stratifié suivant la revendication 17,
dans lequel la couche partielle d'accumulation de charges est
• une couche en silicium polycristallin ayant une succession de couches de dioxyde silicium-nitrure de silicium-dioxyde de silicium (couche ONO) comme couche de finition ; ou
• une succession de couches dioxyde de silicium-nitrure de silicium-dioxyde de silicium (couche ONO).

19. Dispositif stratifié suivant la revendication 17 ou 18,
dans lequel le premier et/ou le deuxième matériau conducteur de l'électricité est du silicium polycristallin.

20. Dispositif stratifié suivant l'une des revendications 17 à 19,
dans lequel indépendamment les uns des autres, le premier, deuxième, troisième, quatrième, cinquième et sixième matériaux isolants du point de vue électrique est
• du dioxyde de silicium ;
• du nitrure de silicium ; ou
• une succession de couches dioxyde de silicium-nitrure de silicium-dioxyde de silicium (couches ONO).

21. Dispositif de mémoire comprenant
un agencement de stratifié suivant l'une des revendications 6 à 16,
dans lequel
• la au moins une première succession de couches sur la première zone de surface du substrat forme au moins une partie de la zone logique du dispositif de mémoire ;
• la au moins une deuxième succession de couches sur la deuxième zone de surface du substrat forme au moins un partie de la zone de cellule de mémoire du dispositif de mémoire.
